(19) Europäisches Patentamt / European Patent Office / Office européen des brevets

(11) **EP 2 904 609 B1**

(12) **EUROPEAN PATENT SPECIFICATION**

(45) Date of publication and mention
of the grant of the patent:
**31.10.2018 Bulletin 2018/44**

(21) Application number: **13773699.7**

(22) Date of filing: **02.10.2013**

(51) Int Cl.:
*G10L 19/008* ^(2013.01)     *G10L 19/02* ^(2013.01)

(86) International application number:
**PCT/EP2013/070533**

(87) International publication number:
**WO 2014/053537 (10.04.2014 Gazette 2014/15)**

(54) **ENCODER, DECODER AND METHODS FOR BACKWARD COMPATIBLE MULTI-RESOLUTION SPATIAL-AUDIO-OBJECT-CODING**

CODIERER, DECODIERER UND VERFAHREN ZUR RÜCKWÄRTSKOMPATIBLEN SPATIAL-AUDIO-OBJECT-CODIERUNG MIT MEHREREN AUFLÖSUNGEN

CODEUR, DÉCODEUR ET PROCÉDÉS POUR CODAGE D'OBJET AUDIO SPATIAL MULTI-RÉSOLUTION RÉTROCOMPATIBLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.10.2012 US 201261710128 P**
**13.05.2013 EP 13167485**

(43) Date of publication of application:
**12.08.2015 Bulletin 2015/33**

(73) Proprietor: **Fraunhofer-Gesellschaft zur Förderung der angewandten Forschung e.V.**
**80686 München (DE)**

(72) Inventors:
  • **DISCH, Sascha**
    **90766 Fürth (DE)**
  • **FUCHS, Harald**
    **91341 Roettenbach (DE)**
  • **PAULUS, Jouni**
    **91052 Erlangen (DE)**
  • **TERENTIV, Leon**
    **91056 Erlangen (DE)**
  • **HELLMUTH, Oliver**
    **91052 Erlangen (DE)**
  • **HERRE, Jürgen**
    **91054 Erlangen (DE)**

(74) Representative: **Zinkler, Franz et al**
    **Schoppe, Zimmermann, Stöckeler Zinkler, Schenk & Partner mbB**
    **Patentanwälte**
    **Radlkoferstrasse 2**
    **81373 München (DE)**

(56) References cited:
    **US-A1- 2007 219 808     US-A1- 2010 087 938**

  • **KYUNGRYEOL KOO ET AL: "Variable Subband Analysis for High Quality Spatial Audio Object Coding", ADVANCED COMMUNICATION TECHNOLOGY, 2008. ICACT 2008. 10TH INTERNATIONAL CONFERENCE ON, IEEE, PISCATAWAY, NJ, USA, 17. Februar 2008 (2008-02-17), Seiten 1205-1208, XP031245331, ISBN: 978-89-5519-136-3**
  • **SEUNGKWON BEACK: "An Efficient Time-Frequency Representation for Parametric-Based Audio Object Coding", ETRI JOURNAL, Bd. 33, Nr. 6, 30. November 2011 (2011-11-30), Seiten 945-948, XP055090173, ISSN: 1225-6463, DOI: 10.4218/etrij.11.0211.0007**

EP 2 904 609 B1

**Description**

The present invention relates to audio signal encoding, audio signal decoding and audio signal processing, and, in particular, to an encoder, a decoder and methods for backward compatible multi-resolution spatial audio object coding (SAOC).

In modern digital audio systems, it is a major trend to allow for audio-object related modifications of the transmitted content on the receiver side. These modifications include gain modifications of selected parts of the audio signal and/or spatial re-positioning of dedicated audio objects in case of multi-channel playback via spatially distributed speakers. This may be achieved by individually delivering different parts of the audio content to the different speakers.

In other words, in the art of audio processing, audio transmission, and audio storage, there is an increasing desire to allow for user interaction on object-oriented audio content playback and also a demand to utilize the extended possibilities of multi-channel playback to individually render audio contents or parts thereof in order to improve the hearing impression. By this, the usage of multi-channel audio content brings along significant improvements for the user. For example, a three-dimensional hearing impression can be obtained, which brings along an improved user satisfaction in entertainment applications. However, multi-channel audio content is also useful in professional environments, for example in telephone conferencing applications, because the talker intelligibility can be improved by using a multi-channel audio playback. Another possible application is to offer to a listener of a musical piece to individually adjust playback level and/or spatial position of different parts (also termed as "audio objects") or tracks, such as a vocal part or different instruments. The user may perform such an adjustment for reasons of personal taste, for easier transcribing one or more part(s) from the musical piece, educational purposes, karaoke, rehearsal, etc.

The straightforward discrete transmission of all digital multi-channel or multi-object audio content, e.g., in the form of pulse code modulation (PCM) data or even compressed audio formats, demands very high bitrates. However, it is also desirable to transmit and store audio data in a bit rate efficient way. Therefore, one is willing to accept a reasonable tradeoff between audio quality and bit rate requirements in order to avoid an excessive resource load caused by multi-channel/multi-object applications.

Recently, in the field of audio coding, parametric techniques for the bit rate-efficient transmission/storage of multi-channel/multi-object audio signals have been introduced by, e.g., the Moving Picture Experts Group (MPEG) and others. One example is MPEG Surround (MPS) as a channel oriented approach [MPS, BCC], or MPEG Spatial Audio Object Coding (SAOC) as an object oriented approach [JSC, SAOC, SAOC1, SAOC2]. Another object-oriented approach is termed as "informed source separation" [ISS1, ISS2, ISS3, ISS4, ISS5, ISS6]. These techniques aim at reconstructing a desired output audio scene or a desired audio source object on the basis of a downmix of channels/objects and additional side information describing the transmitted/stored audio scene and/or the audio source objects in the audio scene.

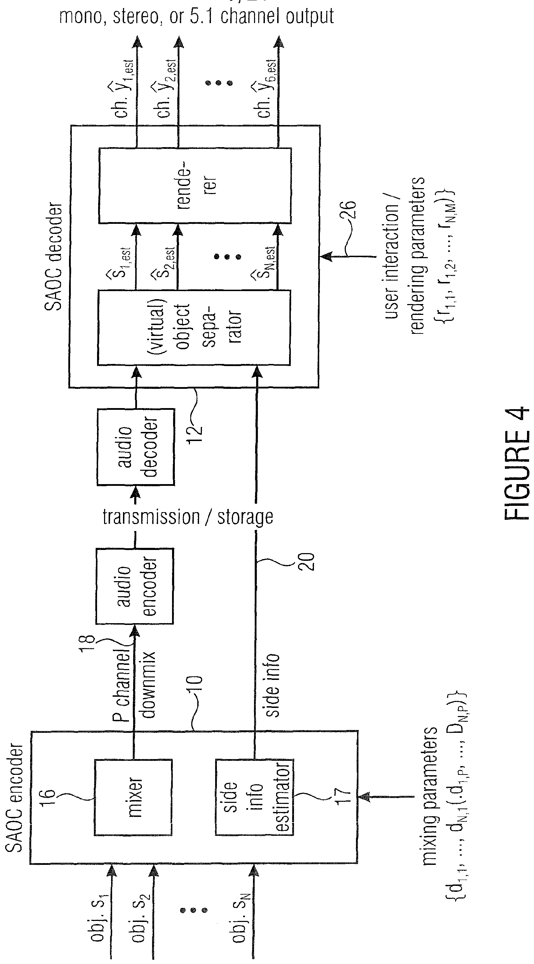

The estimation and the application of channel/object related side information in such systems is done in a time-frequency selective manner. Therefore, such systems employ time-frequency transforms such as the Discrete Fourier Transform (DFT), the Short Time Fourier Transform (STFT) or filter banks like Quadrature Mirror Filter (QMF) banks, etc. The basic principle of such systems is depicted in Fig. 4, using the example of MPEG SAOC.

In case of the STFT, the temporal dimension is represented by the time-block number and the spectral dimension is captured by the spectral coefficient ("bin") number. In case of QMF, the temporal dimension is represented by the time-slot number and the spectral dimension is captured by the sub-band number. If the spectral resolution of the QMF is improved by subsequent application of a second filter stage, the entire filter bank is termed hybrid QMF and the fine resolution sub-bands are termed hybrid sub-bands.

As already mentioned above, in SAOC the general processing is carried out in a time-frequency selective way and can be described as follows within each frequency band:

- $N$ input audio object signals $s_1 \ldots s_N$ are mixed down to $P$ channels $x_1 \ldots x_P$ as part of the encoder processing using a downmix matrix consisting of the elements $d_{1,1} \ldots d_{N,P}$. In addition, the encoder extracts side information describing the characteristics of the input audio objects (Side Information Estimator (SIE) module). For MPEG SAOC, the relations of the object powers w.r.t. each other are the most basic form of such a side information.

- Downmix signal(s) and side information are transmitted/stored. To this end, the downmix audio signal(s) may be compressed, e.g., using well-known perceptual audio coders such MPEG-1/2 Layer II or III (aka .mp3), MPEG-2/4 Advanced Audio Coding (AAC) etc.

- On the receiving end, the decoder conceptually tries to restore the original object signals ("object separation") from the (decoded) downmix signals using the transmitted side information. These approximated object signals $\hat{s}_1 \ldots \hat{s}_N$ are then mixed into a target scene represented by $M$ audio output channels $\hat{y}_1 \ldots \hat{y}_M$ using a rendering matrix described by the coefficients $r_{1,1} \ldots r_{N,M}$ in Fig. 4. The desired target scene may be, in the extreme case, the rendering of only one source signal out of the mixture (source separation scenario), but also any other arbitrary acoustic scene consisting of the objects transmitted. For example, the output can be a single-channel, a 2-channel stereo or 5.1 multi-channel target scene.

Time-frequency based systems may utilize a time-frequency (t/f) transform with static temporal and frequency resolution. Choosing a certain fixed t/f-resolution grid typically involves a trade-off between time and frequency resolution.

The effect of a fixed t/f-resolution can be demonstrated on the example of typical object signals in an audio signal mixture. For example, the spectra of tonal sounds exhibit a harmonically related structure with a fundamental frequency and several overtones. The energy of such signals is concentrated at certain frequency regions. For such signals, a high frequency resolution of the utilized t/f-representation is beneficial for separating the narrowband tonal spectral regions from a signal mixture. In the contrary, transient signals, like drum sounds, often have a distinct temporal structure: substantial energy is only present for short periods of time and is spread over a wide range of frequencies. For these signals, a high temporal resolution of the utilized t/f-representation is advantageous for separating the transient signal portion from the signal mixture.

The frequency resolution obtained from the standard SAOC representation is limited to the number of parametric bands, having the maximum value of 28 in standard SAOC. They are obtained from a hybrid QMF bank consisting of a 64-band QMF-analysis with an additional hybrid filtering stage on the lowest bands further dividing these into up to 4 complex sub-bands. The frequency bands obtained are grouped into parametric bands mimicking the critical band resolution of the human auditory system. The grouping allows for reducing the required side information data rate to a size that can be efficiently handled in practical applications.

Current audio object coding schemes offer only a limited variability in the time-frequency selectivity of the SAOC processing. For instance, MPEG SAOC [SAOC] [SAOC1] [SAOC2] is limited to the time-frequency resolution that can be obtained by the use of the so-called Hybrid Quadrature Mirror Filter Bank (Hybrid-QMF) and its subsequent grouping into parametric bands. Therefore, object restoration in standard SAOC often suffers from the coarse frequency resolution of the Hybrid-QMF leading to audible modulated crosstalk from the other audio objects (e.g., double-talk artifacts in speech or auditory roughness artifacts in music).

Another audio object coding scheme generating base object coding and enhanced object coding with a higher frequency resolution is disclosed by Patent publication US 2010/0087938 A1 (Apr. 8, 2010).

The existing system produces a reasonable separation quality given the reasonably low data rate. The main problem is the insufficient frequency resolution for a clean separation of tonal sounds. This is exhibited as a "halo" of other objects surrounding the tonal components of an object. Perceptually this is observed as roughness or a vocoder-like artefact. The detrimental effect of this halo can be reduced by increasing the parametric frequency resolution. It was noted, that a resolution equal or higher than 512 bands (at 44.1 kHz sampling rate) is enough to produce perceptually significantly improved separation in the test signals. The problem with such a high parametric resolution is that the amount the side information needed increases considerably, into impractical amounts. Furthermore, the compatibility with the existing standard SAOC systems would be lost.

It is therefore highly appreciated, if concepts can be provided which teach how to overcome the above-described restrictions of the state of the art.

The object of the present invention is to provide such improved concepts for audio object coding. The object of the present invention is solved by a decoder according to claim 1, by an encoder according to claim 9, by an encoded audio signal according to claim 14, by a system according to claim 15, by a method for decoding according to claim 16, by a method for encoding according to claim 17 and by a computer program according to claim 18.

In contrast to state-of-the-art SAOC, embodiments of the present invention provide a spectral parameterization, such that

- the SAOC parameter bit streams originating from a standard SAOC encoder can still be decoded by an enhanced decoder with a perceptual quality comparable to the one obtained with a standard decoder,

- the enhanced SAOC parameter bit streams can be decoded with a standard SAOC decoder with a quality comparable to the one obtainable with standard SAOC bit streams,

- the enhanced SAOC parameter bit streams can be decoded with optimal quality with the enhanced decoder,

- the enhanced SAOC decoder can dynamically adjust the enhancement level, e.g., depending on the computational resources available,

- the standard and enhanced SAOC parameter bit streams can be mixed, e.g., in a multi-point control unit (MCU) scenario, into one common bit stream which can be decoded with a standard or an enhanced decoder with the quality provided by the decoder, and

- the additional parameterization is compact.

For the properties mentioned above, it is preferred to have a parameterization which is understood by the standard SAOC decoder, but also allows for an efficient delivery of the information in the higher frequency resolution. The resolution of the underlying time-frequency representation determines the maximum performance of the enhancements. The invention here defines a method for delivering the enhanced high-frequency information in a way which is compact and allows a backwards compatible decoding.

An enhanced SAOC perceptual quality can be obtained, e.g., by dynamically adapting the time/frequency resolution of the filter bank or transform that is employed to estimate or used to synthesize the audio object cues to specific properties of the input audio object. For instance, if the audio object is quasi-stationary during a certain time span, parameter estimation and synthesis is beneficially performed on a coarse time resolution and a fine frequency resolution. If the audio object contains transients or non-stationaries during a certain time span, parameter estimation and synthesis is advantageously done using a fine time resolution and a coarse frequency resolution. Thereby, the dynamic adaptation of the filter bank or transform allows for

- a high frequency selectivity in the spectral separation of quasi-stationary signals in order to avoid inter-object crosstalk, and
- high temporal precision for object onsets or transient events in order to minimize pre- and post-echoes.

At the same time, traditional SAOC quality can be obtained by mapping standard SAOC data onto the time-frequency grid provided by the inventive backward compatible signal adaptive transform that depends on side information describing the object signal characteristics.

Being able to decode both standard and enhanced SAOC data, using one common transform, enables direct backward compatibility for applications that encompass mixing of standard and novel enhanced SAOC data. It also allows a time-frequency selective enhancement over the standard quality.

The provided embodiments are not limited to any specific time-frequency transform, but can be applied with any transform providing sufficiently high frequency resolution. The document describes the application to a Discrete Fourier Transform (DFT) based filter bank with switched time-frequency resolution. In this approach, the time domain signals are subdivided into shorter blocks, which also may overlap. The signal in each shorter block is weighted by a windowing function (normally having large values in the middle and at both ends tapered into zero). Finally the weighted signal is transformed into frequency domain by the selected transform, here, by application of the DFT.

A decoder for generating an un-mixed audio signal comprising a plurality of un-mixed audio channels is provided. The decoder comprises an un-mixing-information determiner for determining un-mixing information by receiving first parametric side information on the at least one audio object signal and second parametric side information on the at least one audio object signal, wherein the frequency resolution of the second parametric side information is higher than the frequency resolution of the first parametric side information. Moreover, the decoder comprises an un-mix module for applying the un-mixing information on a downmix signal, indicating a downmix of at least one audio object signal, to obtain an un-mixed audio signal comprising the plurality of un-mixed audio channels. The un-mixing-information determiner is configured to determine the un-mixing information by modifying the first parametric information and the second parametric information to obtain modified parametric information, such that the modified parametric information has a frequency resolution which is higher than the first frequency resolution.

Moreover, an encoder for encoding one or more input audio object signals is provided. The encoder comprises a downmix unit for downmixing the one or more input audio object signals to obtain one or more downmix signals. Furthermore, the encoder comprises a parametric-side-information generator for generating first parametric side information on the at least one audio object signal and second parametric side information on the at least one audio object signal, such that the frequency resolution of the second parametric side information is higher than the frequency resolution of the first parametric side information.

Furthermore, an encoded audio signal is provided. The encoded audio signal comprises a downmix portion, indicating a downmix of one or more input audio object signals, and a parametric side information portion comprising first parametric side information on the at least one audio object signal and second parametric side information on the at least one audio object signal. The frequency resolution of the second parametric side information is higher than the frequency resolution of the first parametric side information.

Moreover, a system is provided. The system comprises an encoder as described above and a decoder as described above. The encoder is configured to encode one or more input audio object signals by obtaining one or more downmix signals indicating a downmix of one or more input audio object signals, by obtaining first parametric side information on the at least one audio object signal, and by obtaining second parametric side information on the at least one audio object signal, wherein the frequency resolution of the second parametric side information is higher than the frequency resolution of the first parametric side information. The decoder is configured to generate an un-mixed audio signal based on the one or more downmix signals, and based on the first parametric side information and the second parametric side information.

The encoder is configured to encode one or more input audio object signals by obtaining one or more downmix signals indicating a downmix of one or more input audio object signals, by obtaining first parametric side information on the at least one audio object signal, and by obtaining second parametric side information on the at least one audio object signal, wherein the frequency resolution of the second parametric side information is higher than the frequency resolution of the first parametric side information. The decoder is configured to generate an audio output signal based on the one or more downmix signals, and based on the first parametric side information and the second parametric side information.

Furthermore, a method for generating an un-mixed audio signal comprising a plurality of un-mixed audio channels is provided. The method comprises:

- Determining un-mixing information by receiving first parametric side information on the at least one audio object signal and second parametric side information on the at least one audio object signal, wherein the frequency resolution of the second parametric side information is higher than the frequency resolution of the first parametric side information. And:

- Applying the un-mixing information on a downmix signal, indicating a downmix of at least one audio object signal, to obtain an un-mixed audio signal comprising the plurality of un-mixed audio channels.

Determining the un-mixing information comprises modifying the first parametric information and the second parametric information to obtain modified parametric information, such that the modified parametric information has a frequency resolution which is higher than the first frequency resolution.

Moreover, a method for encoding one or more input audio object signals is provided. The method comprises:

- Downmixing the one or more input audio object signals to obtain one or more downmix signals. And:

- Generating first parametric side information on the at least one audio object signal and second parametric side information on the at least one audio object signal, such that the frequency resolution of the second parametric side information is higher than the frequency resolution of the first parametric side information.

Moreover, a computer program for implementing one of the above-described methods when being executed on a computer or signal processor is provided.

Preferred embodiments will be provided in the dependent claims.

In the following, embodiments of the present invention are described in more detail with reference to the figures, in which:

Fig. 1a    illustrates a decoder according to an embodiment,
Fig. 1b    illustrates a decoder according to another embodiment,
Fig. 2a    illustrates an encoder according to an embodiment,
Fig. 2b    illustrates an encoder according to another embodiment,
Fig. 2c    illustrates an encoded audio signal according to an embodiment,
Fig. 3     illustrates a system according to an embodiment,
Fig. 4     shows a schematic block diagram of a conceptual overview of an SAOC system,
Fig. 5     shows a schematic and illustrative diagram of a temporal-spectral representation of a single-channel audio signal,
Fig. 6     shows a schematic block diagram of a time-frequency selective computation of side information within an SAOC encoder,
Fig. 7     illustrates backwards compatible representation according to embodiments,
Fig. 8     illustrates the difference curve between the true parameter value and the low-resolution mean value according to an embodiment,
Fig. 9     depicts a high-level illustration of the enhanced encoder providing a backwards compatible bit stream with enhancements according to an embodiment,
Fig. 10    illustrates a block diagram of an encoder according to a particular embodiment implementing a parametric path of an encoder,
Fig. 11    depicts a high-level block diagram of an enhanced decoder according to an embodiment which is capable of decoding both standard and enhanced bit streams,

Fig. 12    illustrates a block diagram illustrating an embodiment of the enhanced PSI-decoding unit,

Fig. 13    depicts a block diagram of decoding standard SAOC bit streams with the enhanced SAOC decoder according to an embodiment,

Fig. 14    depicts the main functional blocks of the decoder according to an embodiment,

Fig. 15    illustrates a tonal and a noise signal and, in particular, high-resolution power spectra and the corresponding rough reconstructions,

Fig. 16    illustrates the modification for both example signals, in particular the correction factors for the example signals,

Fig. 17    illustrates the original correction factors and the reduced-order linear prediction based approximations for both of the example signals, and

Fig. 18    illustrates the result of applying the modelled correction factors on the rough reconstructions.

Before describing embodiments of the present invention, more background on state-of-the-art-SAOC systems is provided.

Fig. 4 shows a general arrangement of an SAOC encoder 10 and an SAOC decoder 12. The SAOC encoder 10 receives as an input $N$ objects, i.e., audio signals $s_1$ to $s_N$. In particular, the encoder 10 comprises a downmixer 16 which receives the audio signals $s_1$ to $s_N$ and downmixes same to a downmix signal 18. Alternatively, the downmix may be provided externally ("artistic downmix") and the system estimates additional side information to make the provided downmix match the calculated downmix. In Fig. 4, the downmix signal is shown to be a $P$-channel signal. Thus, any mono ($P$=1), stereo ($P$=2) or multi-channel ($P$>2) downmix signal configuration is conceivable.

In the case of a stereo downmix, the channels of the downmix signal 18 are denoted $L0$ and $R0$, in case of a mono downmix same is simply denoted $L0$. In order to enable the SAOC decoder 12 to recover the individual objects $s_1$ to $s_N$, side-information estimator 17 provides the SAOC decoder 12 with side information including SAOC-parameters. For example, in case of a stereo downmix, the SAOC parameters comprise object level differences (OLD), inter-object correlations (IOC) (inter-object cross correlation parameters), downmix gain values (DMG) and downmix channel level differences (DCLD). The side information 20 including the SAOC-parameters, along with the downmix signal 18, forms the SAOC output data stream received by the SAOC decoder 12.

The SAOC decoder 12 comprises an upmixer which receives the downmix signal 18 as well as the side information 20 in order to recover and render the audio signals $\hat{s}_1$ and $\hat{s}_N$ onto any user-selected set of channels $\hat{y}_1$ to $\hat{y}_M$, with the rendering being prescribed by rendering information 26 input into SAOC decoder 12.

The audio signals $s_1$ to $s_N$ may be input into the encoder 10 in any coding domain, such as, in time or spectral domain. In case the audio signals $s_1$ to $s_N$ are fed into the encoder 10 in the time domain, such as PCM coded, encoder 10 may use a filter bank, such as a hybrid QMF bank, in order to transfer the signals into a spectral domain, in which the audio signals are represented in several sub-bands associated with different spectral portions, at a specific filter bank resolution. If the audio signals $s_1$ to $s_N$ are already in the representation expected by encoder 10, same does not have to perform the spectral decomposition.

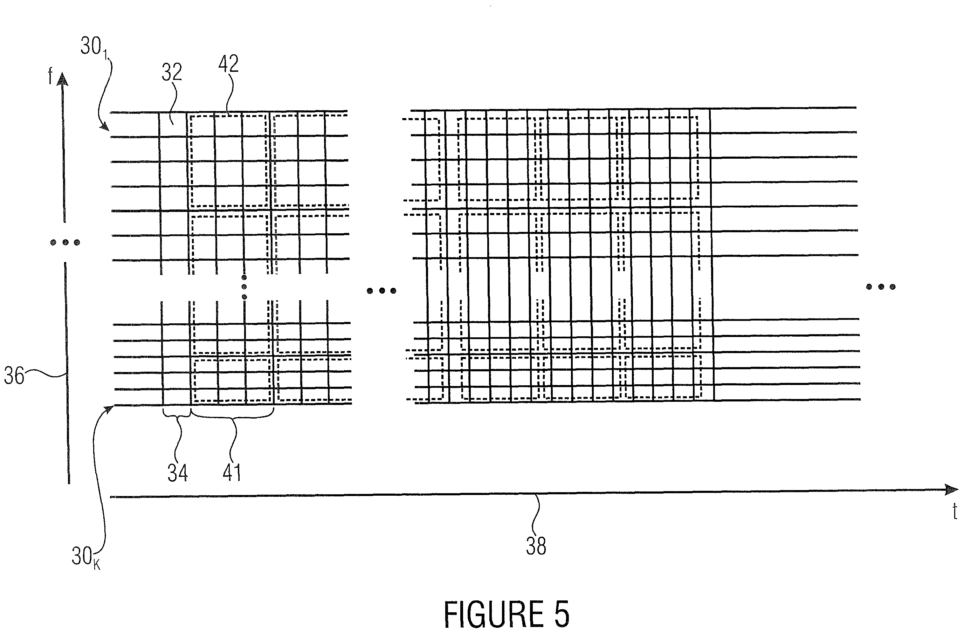

Fig. 5 shows an audio signal in the just-mentioned spectral domain. As can be seen, the audio signal is represented as a plurality of sub-band signals. Each sub-band signal $30_1$ to $30_K$ consists of a temporal sequence of sub-band values indicated by the small boxes 32. As can be seen, the sub-band values 32 of the sub-band signals $30_1$ to $30_K$ are synchronized to each other in time so that, for each of the consecutive filter bank time slots 34, each sub-band $30_1$ to $30_K$ comprises exact one sub-band value 32. As illustrated by the frequency axis 36, the sub-band signals $30_1$ to $30_K$ are associated with different frequency regions, and as illustrated by the time axis 38, the filter bank time slots 34 are consecutively arranged in time.

As outlined above, side-information extractor 17 of Fig. 4 computes SAOC-parameters from the input audio signals $s_1$ to $s_N$. According to the currently implemented SAOC standard, encoder 10 performs this computation in a time/frequency resolution which may be decreased relative to the original time/frequency resolution as determined by the filter bank time slots 34 and sub-band decomposition, by a certain amount, with this certain amount being signaled to the decoder side within the side information 20. Groups of consecutive filter bank time slots 34 may form a SAOC frame 41. Also the number of parameter bands within the SAOC frame 41 is conveyed within the side information 20. Hence, the time/frequency domain is divided into time/frequency tiles exemplified in Fig. 5 by dashed lines 42. In Fig. 5 the parameter bands are distributed in the same manner in the various depicted SAOC frames 41 so that a regular arrangement of time/frequency tiles is obtained. In general, however, the parameter bands may vary from one SAOC frame 41 to the subsequent, depending on the different needs for spectral resolution in the respective SAOC frames 41. Furthermore, the length of the SAOC frames 41 may vary, as well. As a consequence, the arrangement of time/frequency tiles may be irregular. Nevertheless, the time/frequency tiles within a particular SAOC frame 41 typically have the same duration and are aligned in the time direction, i.e., all t/f-tiles in said SAOC frame 41 start at the start of the given SAOC frame 41 and end at the end of said SAOC frame 41.

The side information extractor 17 depicted in Fig. 4 calculates SAOC parameters according to the following formulas. In particular, side information extractor 17 computes object level differences for each object $i$ as

$$OLD_i^{l,m} = \frac{\sum_{n\in l}\sum_{k\in m} x_i^{n,k} x_i^{n,k*}}{\max_j\left(\sum_{n\in l}\sum_{k\in m} x_j^{n,k} x_j^{n,k*}\right)}$$

wherein the sums and the indices $n$ and $k$, respectively, go through all temporal indices 34, and all spectral indices 30 which belong to a certain time/frequency tile 42, referenced by the indices $l$ for the SAOC frame (or processing time slot) and $m$ for the parameter band, and $x_i^{n,k*}$ is the complex conjugate of $x_i^{n,k}$. Thereby, the energies of all sub-band values $x_i$ of an audio signal or object $i$ are summed up and normalized to the highest energy value of that tile among all objects or audio signals.

Further, the SAOC side information extractor 17 is able to compute a similarity measure of the corresponding time/frequency tiles of pairs of different input objects $s_1$ to $s_N$. Although the SAOC side information extractor 17 may compute the similarity measure between all the pairs of input objects $s_1$ to $s_N$, SAOC side information extractor 17 may also suppress the signaling of the similarity measures or restrict the computation of the similarity measures to audio objects $s_1$ to $s_N$ which form left or right channels of a common stereo channel. In any case, the similarity measure is called the inter-object cross-correlation parameter $IOC_{i,j}^{l,m}$. The computation is as follows

$$IOC_{i,j}^{l,m} = IOC_{j,i}^{l,m} = \mathrm{Re}\left\{\frac{\sum_{n\in l}\sum_{k\in m} x_i^{n,k} x_j^{n,k*}}{\sqrt{\sum_{n\in l}\sum_{k\in m} x_i^{n,k} x_i^{n,k*}\sum_{n\in l}\sum_{k\in m} x_j^{n,k} x_j^{n,k*}}}\right\}$$

with again indices $n$ and $k$ going through all sub-band values belonging to a certain time/frequency tile 42, $i$ and $j$ denoting a certain pair of audio objects $s_1$ to $s_N$, and Re{ } denoting the operation of retaining only the real part (i.e., discarding the imaginary part) of the complex-valued argument.

The downmixer 16 of Fig. 4 downmixes the objects $s_1$ to $s_N$ by use of gain factors applied to each object $s_1$ to $s_N$. That is, a gain factor $d_i$ is applied to object $i$ and then all thus weighted objects $s_1$ to $s_N$ are summed up to obtain a mono downmix signal, which is exemplified in Fig. 4 if $P=1$. In another example case of a two-channel downmix signal, depicted in Fig. 4 if $P=2$, a gain factor $d_{1,i}$ is applied to object $i$ and then all such gain amplified objects are summed in order to obtain the left downmix channel $L0$, and gain factors $d_{2,i}$ are applied to object $i$ and then the thus gain-amplified objects are summed in order to obtain the right downmix channel $R0$. A processing that is analogous to the above is to be applied in case of a multi-channel downmix ($P>2$).

This downmix prescription is signaled to the decoder side by means of down mix gains $DMG_i$ and, in case of a stereo downmix signal, downmix channel level differences $DCLD_i$.

The downmix gains are calculated according to:

$$DMG_i = 20\log_{10}\left(d_i + \varepsilon\right) \qquad \text{, (mono downmix),}$$

$$DMG_i = 10\log_{10}\left(d_{1,i}^2 + d_{2,i}^2 + \varepsilon\right) \quad \text{, (stereo downmix),}$$

where $\varepsilon$ is a small number such as $10^{-9}$.

For the DCLDs the following formula applies:

$$DCLD_i = 20\log_{10}\left(\frac{d_{1,i}}{d_{2,i} + \varepsilon}\right).$$

In the normal mode, downmixer 16 generates the downmix signal according to:

$$(L0) = (d_i) \begin{pmatrix} s_1 \\ \vdots \\ s_N \end{pmatrix}$$

for a mono downmix, or

$$\begin{pmatrix} L0 \\ R0 \end{pmatrix} = \begin{pmatrix} d_{1,i} \\ d_{2,i} \end{pmatrix} \begin{pmatrix} s_1 \\ \vdots \\ s_N \end{pmatrix}$$

for a stereo downmix, respectively.

Thus, in the abovementioned formulas, parameters OLD and IOC are a function of the audio signals, and parameters DMG and DCLD are functions of the downmix coefficients $d$. By the way, it is noted that $d$ may be varying in time and frequency.

Thus, in the normal mode, downmixer 16 mixes all objects $s_1$ to $s_N$ with no preferences, i.e., with handling all objects $s_1$ to $s_N$ equally.

At the decoder side, the upmixer performs the inversion of the downmix procedure and the implementation of the "rendering information" 26 represented by a matrix **R** (in the literature sometimes also called **A**) in one computation step, namely, in case of a two-channel downmix

$$\begin{pmatrix} \hat{y}_1 \\ \vdots \\ \hat{y}_M \end{pmatrix} = \mathbf{RED}^* (\mathbf{DED}^*)^{-1} \begin{pmatrix} L0 \\ R0 \end{pmatrix},$$

where matrix **E** is a function of the parameters OLD and IOC, and the matrix **D** contains the downmixing coefficients as

$$\mathbf{D} = \begin{pmatrix} d_{1,1} & \cdots & d_{1,N} \\ \vdots & \ddots & \vdots \\ d_{P,1} & \cdots & d_{P,N} \end{pmatrix},$$

and wherein **D\*** denotes the complex transpose of **D**. The matrix **E** is an estimated covariance matrix of the audio objects $s_1$ to $s_N$. In current SAOC implementations, the computation of the estimated covariance matrix **E** is typically performed in the spectral/temporal resolution of the SAOC parameters, i.e., for each $(l,m)$, so that the estimated covariance matrix may be written as $\mathbf{E}^{l,m}$. The estimated covariance matrix $\mathbf{E}^{l,m}$ is of size $N$ x $N$ with its coefficients being defined as

$$e_{i,j}^{l,m} = \sqrt{OLD_i^{l,m} OLD_j^{l,m}} \, IOC_{i,j}^{l,m} .$$

Thus, the matrix $\mathbf{E}^{l,m}$ with

$$E^{l,m} = \begin{pmatrix} e_{1,1}^{l,m} & \cdots & e_{1,N}^{l,m} \\ \vdots & \ddots & \vdots \\ e_{N,1}^{l,m} & \cdots & e_{N,N}^{l,m} \end{pmatrix}$$

has along its diagonal the object level differences, i.e., $e_{i,j}^{l,m} = OLD_i^{l,m}$ for $i=j$, since $OLD_i^{l,m} = OLD_j^{l,m}$ and

$IOC_{i,j}^{l,m} = 1$ for $i=j$. for $i=j$. Outside its diagonal the estimated covariance matrix **E** has matrix coefficients representing the geometric mean of the object level differences of objects $i$ and $j$, respectively, weighted with the inter-object

cross correlation measure $IOC_{i,j}^{l,m}$.

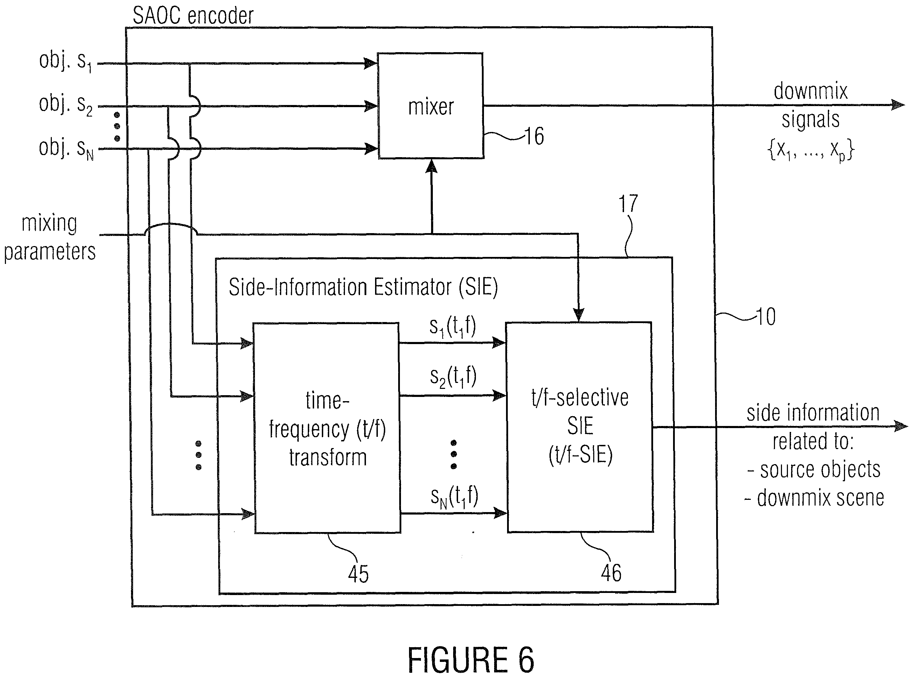

Fig. 6 displays one possible principle of implementation on the example of the Side Information Estimator (SIE) as part of a SAOC encoder 10. The SAOC encoder 10 comprises the mixer 16 and the Side Information Estimator (SIE) 17. The SIE conceptually consists of two modules: One module 45 to compute a short-time based t/f-representation (e.g., STFT or QMF) of each signal. The computed short-time t/f-representation is fed into the second module 46, the t/f-selective Side Information Estimation module (t/f-SIE). The t/f-SIE module 46 computes the side information for each t/f-tile. In current SAOC implementations, the time/frequency transform is fixed and identical for all audio objects $s_1$ to $s_N$. Furthermore, the SAOC parameters are determined over SAOC frames which are the same for all audio objects and have the same time/frequency resolution for all audio objects $s_1$ to $s_N$, thus disregarding the object-specific needs for fine temporal resolution in some cases or fine spectral resolution in other cases.

In the following, embodiments of the present invention are described.

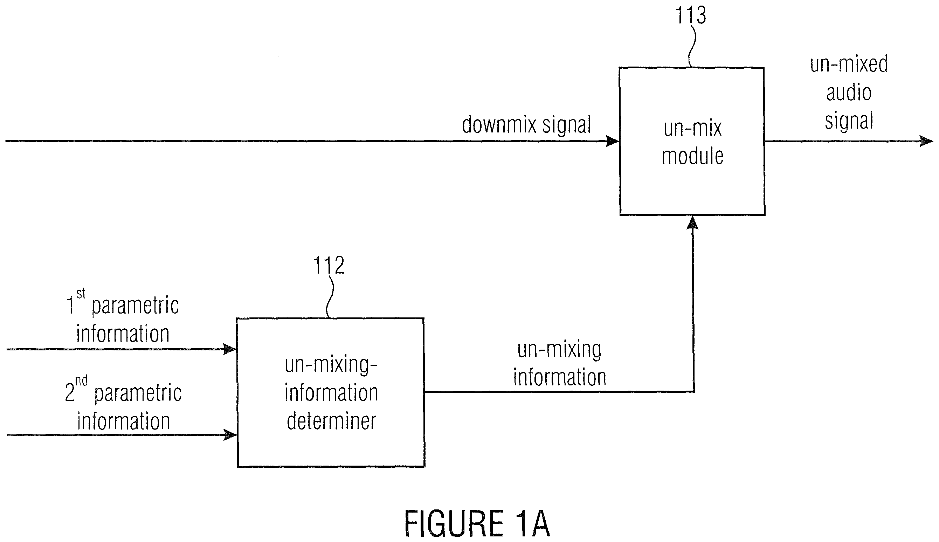

Fig. 1a illustrates a decoder for generating an un-mixed audio signal comprising a plurality of un-mixed audio channels according to an embodiment.

The decoder comprises an un-mixing-information determiner 112 for determining un-mixing information by receiving first parametric side information on the at least one audio object signal and second parametric side information on the at least one audio object signal, wherein the frequency resolution of the second parametric side information is higher than the frequency resolution of the first parametric side information.

Moreover, the decoder comprises an un-mix module 113 for applying the un-mixing information on a downmix signal, indicating a downmix of at least one audio object signal, to obtain an un-mixed audio signal comprising the plurality of un-mixed audio channels.

The un-mixing-information determiner 112 is configured to determine the un-mixing information by modifying the first parametric information and the second parametric information to obtain modified parametric information, such that the modified parametric information has a frequency resolution which is higher than the first frequency resolution.

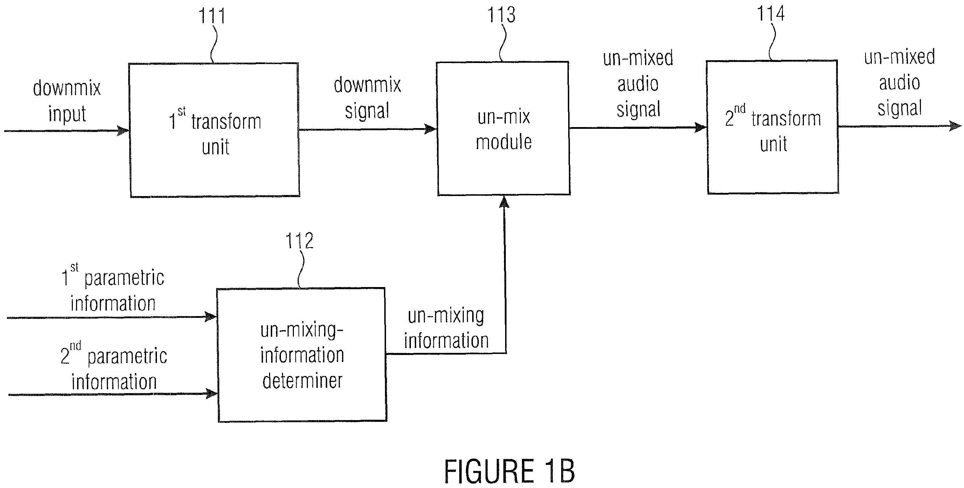

Fig. 1b illustrates a decoder for generating an un-mixed audio signal comprising a plurality of un-mixed audio channels according to another embodiment. The decoder of Fig. 1b furthermore comprises a first transform unit 111 for transforming a downmix input, being represented in a time domain, to obtain the downmix signal, being represented in a time-frequency domain. Furthermore, the decoder of Fig. 1b comprises a second transform unit 114 for transforming the un-mixed audio signal from the time-frequency domain to the time domain.

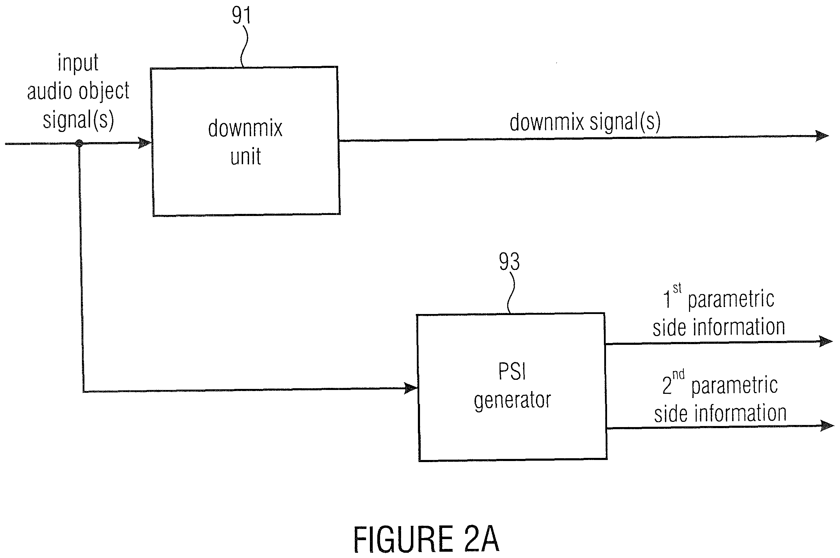

Fig. 2a illustrates an encoder for encoding one or more input audio object signals according to an embodiment.

The encoder comprises a downmix unit 91 for downmixing the one or more input audio object signals to obtain one or more downmix signals.

Furthermore, the encoder comprises a parametric-side-information generator 93 for generating first parametric side information on the at least one audio object signal and second parametric side information on the at least one audio object signal, such that the frequency resolution of the second parametric side information is higher than the frequency resolution of the first parametric side information.

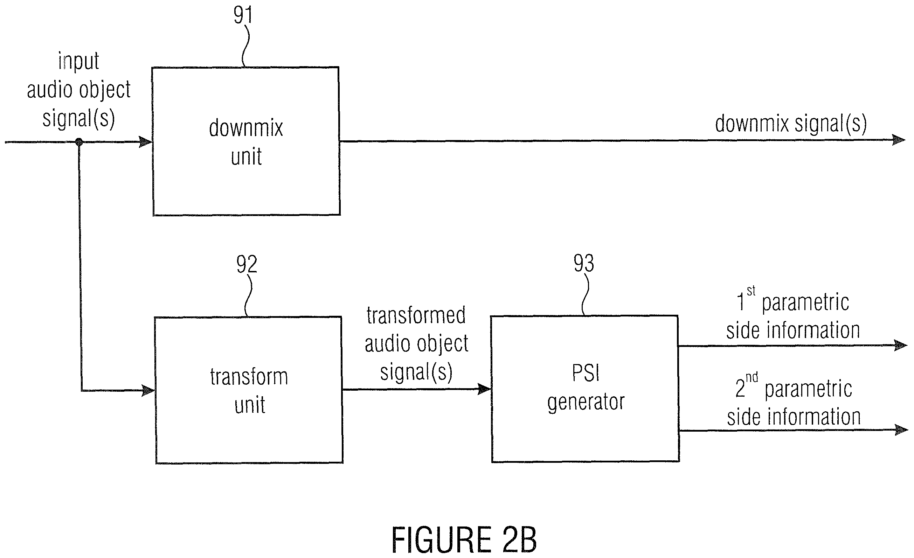

Fig. 2b illustrates an encoder for encoding one or more input audio object signals according to another embodiment. The encoder of Fig. 2b further comprises a transform unit 92 for transforming the one or more input audio object signals from a time domain to a time-frequency domain to obtain one or more transformed audio object signals. In the embodiment of Fig. 2b, the parametric-side-information generator 93 is configured to generate the first parametric side information and the second parametric side information based on the one or more transformed audio object signals.

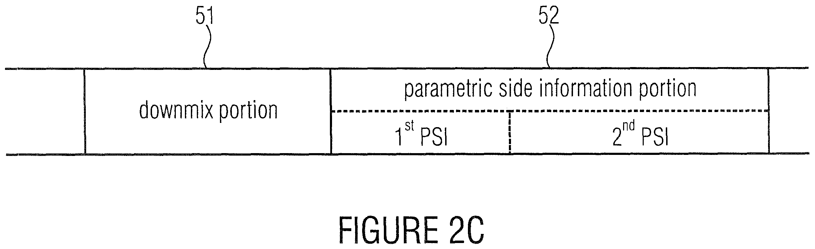

Fig. 2c illustrates an encoded audio signal according to an embodiment. The encoded audio signal comprises a downmix portion 51, indicating a downmix of one or more input audio object signals, and a parametric side information portion 52 comprising first parametric side information on the at least one audio object signal and second parametric side information on the at least one audio object signal. The frequency resolution of the second parametric side information is higher than the frequency resolution of the first parametric side information.

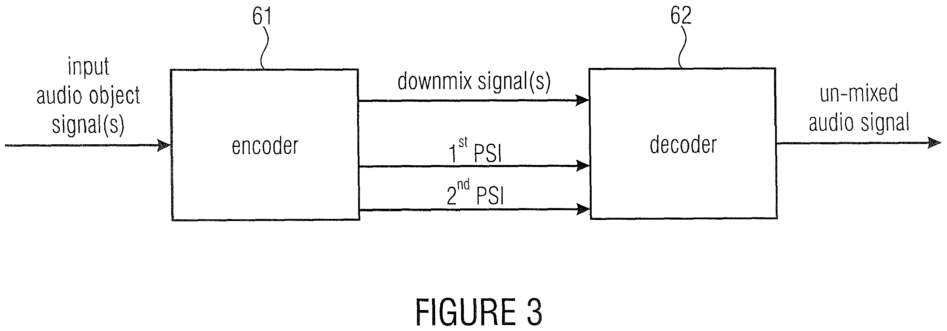

Fig. 3 illustrates a system according to an embodiment. The system comprises an encoder 61 as described above and a decoder 62 as described above.

The encoder 61 is configured to encode one or more input audio object signals by obtaining one or more downmix signals indicating a downmix of one or more input audio object signals, by obtaining first parametric side information on the at least one audio object signal, and by obtaining second parametric side information on the at least one audio object signal, wherein the frequency resolution of the second parametric side information is higher than the frequency resolution of the first parametric side information.

The decoder 62 is configured to generate an un-mixed audio signal based on the one or more downmix signals, and based on the first parametric side information and the second parametric side information.

In the following, enhanced SAOC using backward compatible frequency resolution improvement is described.

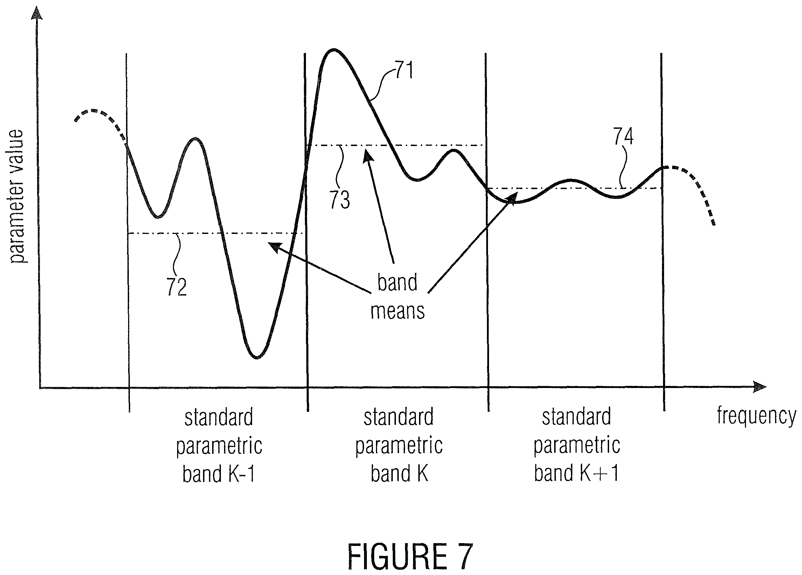

Fig. 7 illustrates backwards compatible representation according to embodiments. The signal property to be represented, e.g., the power spectral envelope 71, varies over the frequency. The frequency axis is partitioned into parametric bands, and a single set of signal descriptors are assigned for each sub-band. Using them instead of delivering the description for each frequency bin separately allows for savings in the amount of the side information required without a significant loss in the perceptual quality. In the standard SAOC, the single descriptor for each band is the mean value 72, 73, 74 of the bin-wise descriptors. As can be understood, this may introduce a loss of information whose magnitude depends on the signal properties. In Fig. 7, the bands $k - 1$ and $k$ have quite a large error, while in the band $k + 1$ the error is much smaller.

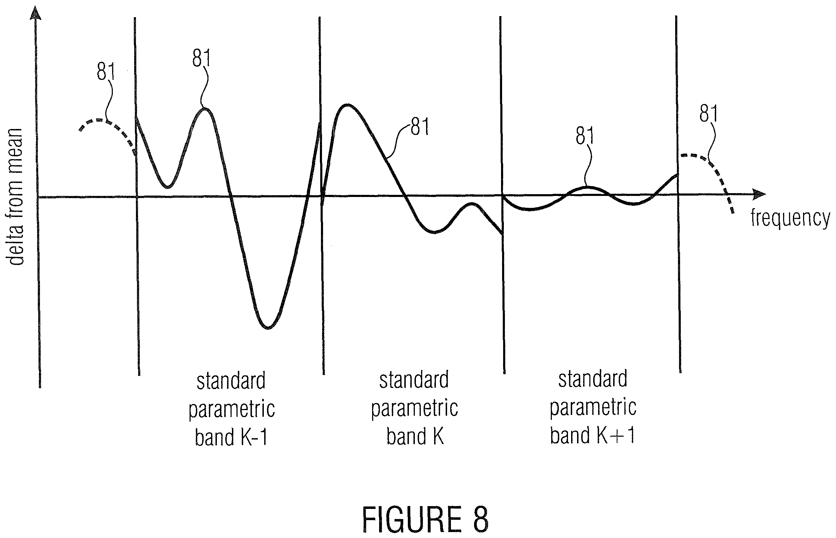

Fig. 8 illustrates the difference curve 81 between the true parameter value and the low-resolution mean value according to an embodiment, e.g., the fine structure information lost in the standard SAOC parameterization. We describe a method for parameterizing and transmitting the difference curves 81 between the mean values 72, 73, 74 (e.g., the standard SAOC descriptor) and the true, fine-resolution values in an efficient manner allowing approximating the fine-resolution structure in the decoder.

It should be noted that adding the enhancement information to a single object in a mixture does not only improve the resulting quality of that specific object, but the quality of all objects sharing the approximate spatial location and having some spectral overlap.

In the following, backward compatible enhanced SAOC encoding with an enhanced encoder is described, in particular, an enhanced SAOC encoder which produces a bit stream containing a backward compatible side information portion and additional enhancements. The added information can be inserted into the standard SAOC bit stream in such a way that the old, standard-compliant decoders simply ignore the added data while the enhanced decoders make use of it. The existing standard SAOC decoders can decode the backward compatible portion of the parametric side information (PSI) and produce reconstructions of the objects, while the added information used by the enhanced SAOC decoder improves the perceptual quality of the reconstructions in most of the cases. Additionally, if the enhanced SAOC decoder is running on limited resources, the enhancements can be ignored and a basic quality reconstruction is still obtained. It should be noted that the reconstructions from standard SAOC and enhanced SAOC decoders using only the standard SAOC compatible PSI differ, but are judged to be perceptually very similar (the difference is of the similar nature as in decoding standard SAOC bit streams with an enhanced SAOC decoder).

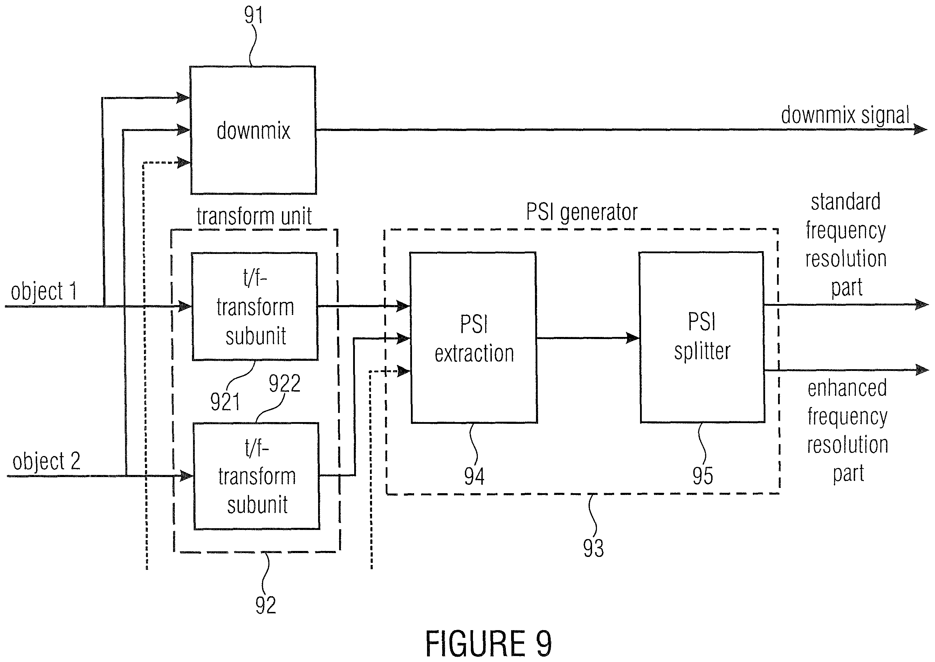

Fig. 9 depicts a high-level illustration of the enhanced encoder providing a backwards compatible bit stream with enhancements according to an embodiment.

The encoder comprises a downmix unit 91 for downmixing a plurality of audio object signals to obtain one or more downmix signals. For example, the audio object signals (e.g., the individual (audio) objects) are used by a downmix unit 91 to create a downmix signal. This may happen in time domain, frequency domain, or even an externally provided downmix can be used.

In the PSI-path, the (audio) object signals are transformed by a transform unit 92 from a time domain to a frequency domain, a time-frequency domain or a spectral domain (for example, by a transform unit 92 comprising one or more t/f-transform subunits 921, 922).

Moreover, the encoder comprises a parametric-side-information generator 93 for generating parametric side information. In the embodiment of Fig. 9, the parametric-side-information generator 93, may, for example, comprise a PSI-extraction unit 94 and a PSI splitter 95. According to such an embodiment, in the frequency domain, the PSI is extracted by the PSI-extraction unit 94. The PSI splitter 95 is then conducted to split the PSI into two parts: the standard frequency resolution part that can be decoded with any standard-compliant SAOC-decoder, and the enhanced frequency resolution part. The latter may be "hidden" in bit stream elements, such that these will be ignored by the standard decoders but utilized by the enhanced decoders.

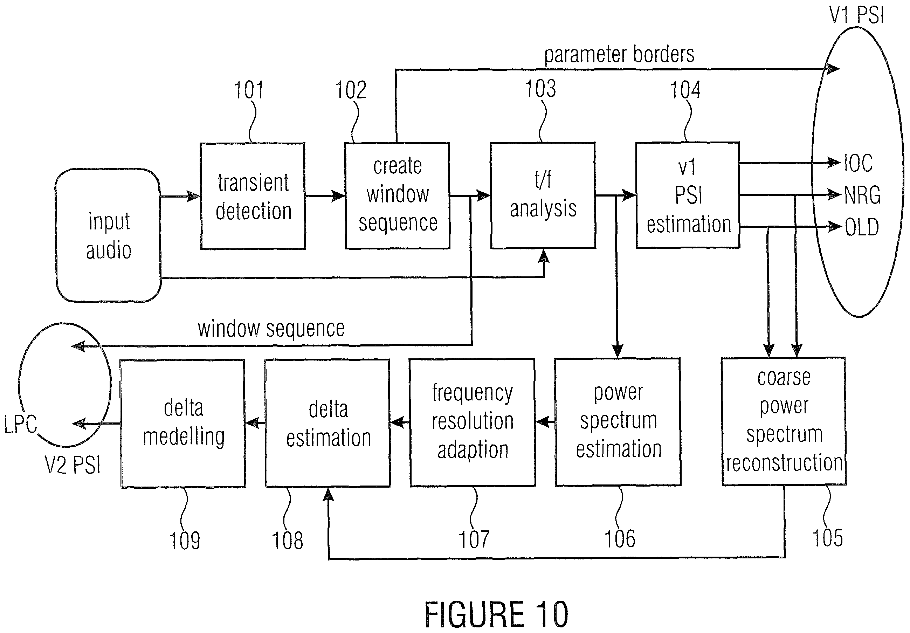

Fig. 10 illustrates a block diagram of an encoder according to a particular embodiment implementing the parametric path of the encoder described above. Bold black functional blocks (102, 105, 106, 107, 108, 109) indicate the main components of the inventive processing. In particular, Fig. 10 illustrates a block diagram of two-stage encoding producing backward-compatible bit stream with enhancements for more capable decoders. The encoder is configured to produce PSI that can be decoded with both decoder versions. The transform unit 92 of Fig. 9 is implemented by a transient-detection unit 101, by a create-window-sequence unit 102, and by a t/f-analysis unit 103 in Fig. 10. The other units 104, 105, 106, 107, 108, 109 in Fig. 10 implement the parametric-side-information generator 93 (e.g. the units 104, 105, 106, 107, 108, 109 may implement the functionality of the combination of the PSI-extraction unit 94 and the PSI splitter 95).

First, the signal is subdivided into analysis frames, which are then transformed into the frequency domain. Multiple analysis frames are grouped into a fixed-length parameter frame, e.g., in standard SAOC lengths of 16 and 32 analysis frames are common. It is assumed that the signal properties remain quasi-stationary during the parameter frame and can thus be characterized with only one set of parameters. If the signal characteristics change within the parameter frame, modeling error is suffered, and it would be beneficial to sub-divide the longer parameter frame into parts in which the assumption of quasi-stationarity is again fulfilled. For this purpose, transient detection is needed.

In an embodiment, the transform unit 92 is configured to transform one or more input audio object signals from the time domain to the time-frequency domain depending on a window length of a signal transform block comprising signal values of at least one of the one or more input audio object signals. The transform unit 92 comprises a transient-detection unit 101 for determining a transient detection result indicating whether a transient is present in one or more of the at least one audio object signals, wherein a transient indicates a signal change in one or more of the at least one audio object signals. Moreover, the transform unit 92 further comprises a window sequence unit 102 for determining the window length depending on the transient detection result.

For example, the transients may be detected by the transient-detection unit 101 from all input objects separately, and when there is a transient event in only one of the objects that location is declared as a global transient location. The information of the transient locations is used for constructing an appropriate windowing sequence. The construction can be based, for example, on the following logic:

- Set a default window length, i.e., the length of a default signal transform block, e.g., 2048 samples.

- Set parameter frame length, e.g., 4096 samples, corresponding to 4 default windows with 50% overlap. Parameter frames group multiple windows together and a single set of signal descriptors are used for the entire block instead of having descriptors for each window separately. This allows reducing the amount of PSI.

- If no transient has been detected, use the default windows and the full parameter frame length.

- If a transient is detected, adapt the windowing to provide a better temporal resolution at the location of the transient.

The create-window-sequence unit 102 constructs the windowing sequence. At the same time, it also creates parameter sub-frames from one or more analysis windows. Each subset is analyzed as an entity and only one set of PSI-parameters are transmitted for each sub-block. To provide a standard SAOC compatible PSI, the defined parameter block length is used as the main parameter block length, and the possible located transients within that block define parameter subsets.

The constructed window sequence is outputted for time-frequency analysis of the input audio signals conducted by the t/f-analysis unit 103, and transmitted in the enhanced SAOC enhancement portion of the PSI.

The PSI consists of sets of object level differences (OLD), inter-object correlations (IOC), and information of the downmix matrix **D** used to create the downmix signal from the individual objects in the encoder. Each parameter set is associated with a parameter border which defines the temporal region to which the parameters are associated to.

The spectral data of each analysis window is used by the PSI-estimation unit 104 for estimating the PSI for standard SAOC part. This is done by grouping the spectral bins into parametric bands of standard SAOC and estimating the IOCs, OLDs and absolute objects energies (NRG) in the bands. Following loosely the notation of standard SAOC, the normalized product of two object spectra $\mathbf{S}_i(f,n)$ and $\mathbf{S}_j(f,n)$ in a parameterization tile is defined as

$$nrg_{i,j}(b) = \frac{\sum_{n=0}^{N-1}\sum_{f=0}^{F_n-1} \mathbf{K}(b,f,n)\mathbf{S}_i(f,n)\mathbf{S}_j^*(f,n)}{\sum_{n=0}^{N-1}\sum_{f=0}^{F_n-1} \mathbf{K}(b,f,n)},$$

where the matrix $\mathbf{K}(b,f,n):\mathbb{R}^{B \times F_n \times N}$ defines the mapping from the $F_n$ t/f-representation bins in frame $n$ into $B$ parametric bands by

$$\mathbf{K}(b,f,n) = \begin{cases} 1, & \text{if } f \in b \\ 0, & \text{otherwise} \end{cases}.$$

The spectral resolution can vary between the frames within a single parametric block, so the mapping matrix converts the data into a common resolution basis. The maximum object energy in this parameterization tile is defined

$$NRG(b) = \max_i(nrg_{i,i}(b)).$$

to be the maximum object energy Having this value, the OLDs are then defined to be the normalized object energies

$$OLD_i(b) = \frac{nrg_{i,i}(b)}{NRG(b)}.$$

And finally the IOC can be obtained from the cross-powers as

$$IOC_{i,j}(b) = \mathrm{Re}\left\{\frac{nrg_{i,j}(b)}{\sqrt{nrg_{i,i}(b)nrg_{j,j}(b)}}\right\}.$$

This concludes the estimation of the standard SAOC compatible parts of the bit stream.

A coarse-power-spectrum-reconstruction unit 105 is configured to use the OLDs and NRGs for reconstructing a rough estimate of the spectral envelope in the parameter analysis block. The envelope is constructed in the highest frequency resolution used in that block.

The original spectrum of each analysis window is used by a power-spectrum-estimation unit 106 for calculating the power spectrum in that window.

The obtained power spectra are transformed into a common high frequency resolution representation by a frequency-resolution-adaptation unit 107. This can be done, for example, by interpolating the power spectral values. Then the mean power spectral profile is calculated by averaging the spectra within the parameter block. This corresponds roughly to OLD-estimation omitting the parametric band aggregation. The obtained spectral profile is considered as the fine-resolution OLD.

The encoder further comprises a delta-estimation unit 108 for estimating a plurality of correction factors by dividing each of the plurality of OLDs of one of the at least one audio object signal by a value of a power spectrum reconstruction of said one of the at least one audio object signal to obtain the second parametric side information, wherein said plurality of OLDs has a higher frequency resolution than said power spectrum reconstruction.

In an embodiment, the delta-estimation unit 108 is configured to estimate a plurality of correction factors based on a plurality of parametric values depending on the at least one audio object signal to obtain the second parametric side information. E.g., the delta-estimation unit 108 may be configured to estimate a correction factor, "delta", for example, by dividing the fine-resolution OLD by the rough power spectrum reconstruction. As a result, this provides for each frequency bin a (for example, multiplicative) correction factor that can be used for approximating the fine-resolution OLD given the rough spectra.

Finally, a delta-modeling unit 109 is configured to model the estimated correction factor in an efficient way for transmission. One possibility for modeling using Linear Prediction Coefficients (LPC) is described later below.

Effectively, the enhanced SAOC modifications consist of adding the windowing sequence information and the parameters for transmitting the "delta" to the bit stream.

In the following, an enhanced decoder is described.

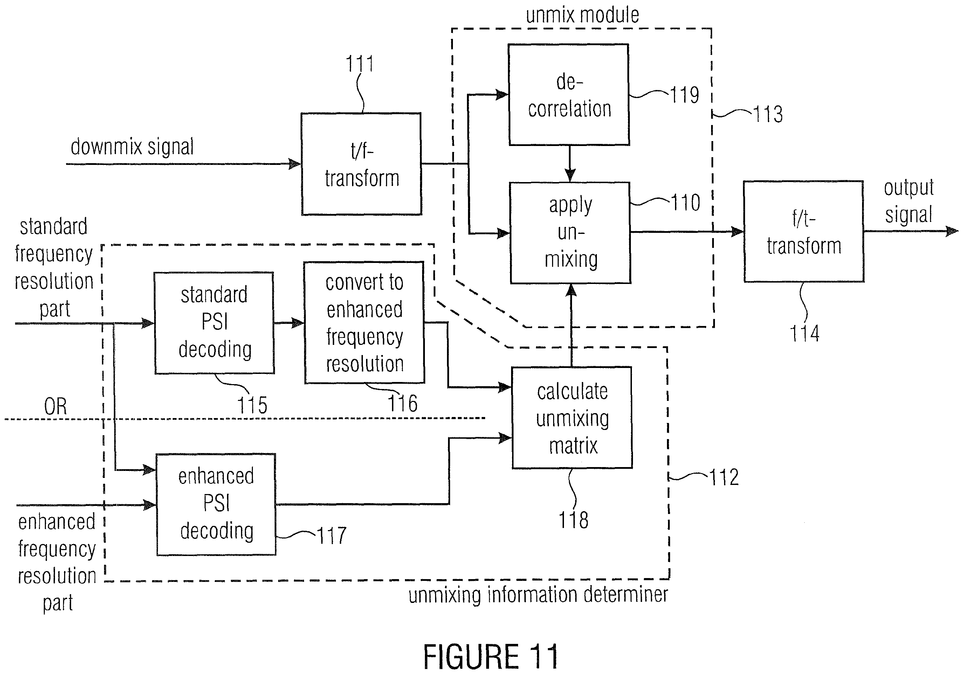

Fig. 11 depicts a high-level block diagram of an enhanced decoder according to an embodiment which is capable of decoding both standard and enhanced bit streams. In particular, Fig. 11 illustrates an operational block diagram of an enhanced decoder capable of decoding both standard bit streams as well as bit streams including frequency resolution enhancements.

The input downmix signal is transformed into frequency domain by a t/f-transform unit 111.

The estimated un-mixing matrix is applied on the transformed downmix signal by an un-mixing unit 110 to generate an un-mixing output.

Additionally, a decorrelation path is included to allow a better spatial control of the objects in the un-mixing. A decorrelation unit 119 conducts decorrelation on the transformed downmix signal and the result of the decorrelation is fed into the un-mixing unit 110. The un-mixing unit 110 uses the decorrelation result for generating the un-mixing output.

The un-mixing output is then transformed back into the time domain by a f/t-transform unit 114.

The parametric processing path can take standard resolution PSI as the input, in which case the decoded PSI, which is generated by a standard-PSI-decoding unit 115, is adapted by a frequency-resolution-conversion unit 116 to the frequency resolution used in the t/f-transforms.

An alternative input combines the standard frequency resolution part of the PSI with the enhanced frequency resolution part and the calculations include the enhanced frequency resolution information. In more detail, an enhanced PSI-decoding unit 117 generates decoded PSI exhibiting enhanced frequency resolution.

An un-mixing-matrix generator 118 generates an un-mixing matrix based on the decoded PSI received from the frequency-resolution-conversion unit 116 or from the enhanced PSI-decoding unit 117. The un-mixing-matrix generator 118 may also generate the un-mixing matrix based on rendering information, for example, based on a rendering matrix. The un-mixing unit 110 is configured to generate the un-mixing output by applying this un-mixing matrix, being generated by the un-mixing-matrix generator 118, on the transformed downmix signal.

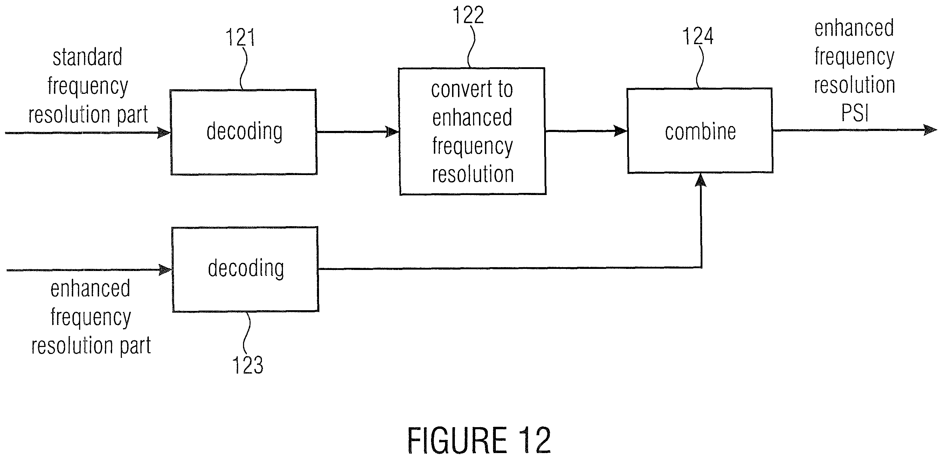

Fig. 12 illustrates a block diagram illustrating an embodiment of the enhanced PSI-decoding unit 117 of Fig. 11.

The first parametric information comprises a plurality of first parameter values, wherein the second parametric information comprises a plurality of second parameter values. The un-mixing-information determiner 112 comprises a frequency-resolution-conversion subunit 122 and a combiner 124. The frequency-resolution-conversion unit 112 is configured to generate additional parameter values, e.g., by replicating the first parameter values, wherein the first parameter values and the additional parameter values together form a plurality of first processed parameter values. The combiner 124 is configured to combine the first processed parameter values and the second parameter values to obtain a plurality of modified parameter values as the modified parametric information.

According to an embodiment, the standard frequency resolution part is decoded by a decoding subunit 121 and converted by a frequency-resolution-conversion subunit 122 into the frequency resolution used by the enhancement part. The decoded enhancement part, generated by an enhanced PSI-decoding subunit 123, is combined by a combiner 124 with the converted standard-resolution part.

In the following, the two decoding modes with possible implementations are described in more detail.

At first, decoding of standard SAOC bit streams with an enhanced decoder is described:
The enhanced SAOC decoder is designed so that it is capable decoding bit streams from standard SAOC encoders with a good quality. The decoding is limited to the parametric reconstruction only, and possible residual streams are ignored.

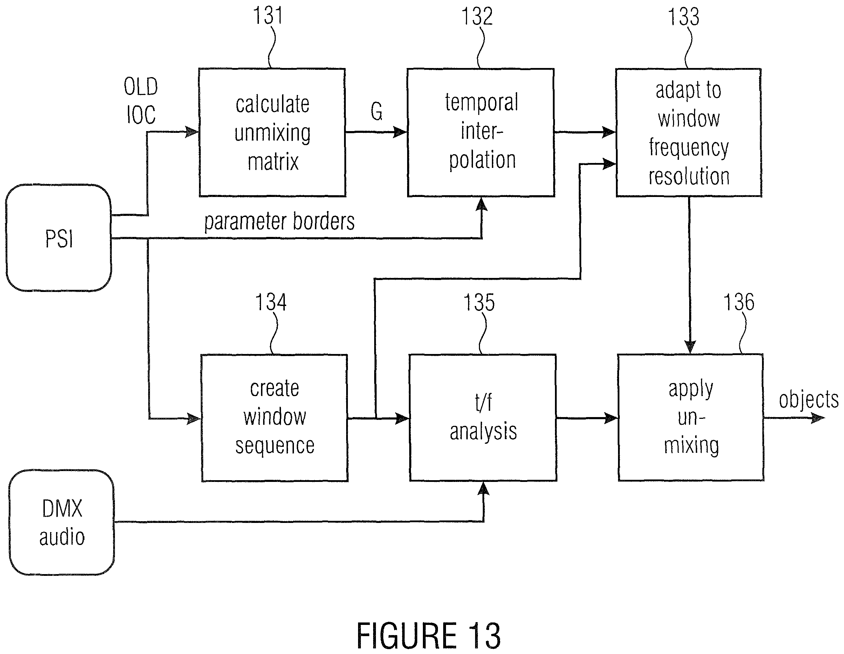

Fig. 13 depicts a block diagram of decoding standard SAOC bit streams with the enhanced SAOC decoder illustrating the decoding process according to an embodiment. Bold black functional blocks (131, 132, 133, 135) indicate the main part of the inventive processing.

An un-mixing-matrix calculator 131, a temporal interpolator 132, and a window-frequency-resolution-adaptation unit 133 implement the functionality of the standard-PSI-decoding unit 115, of the frequency-resolution-conversion unit 116, and of the un-mixing-matrix generator 118 of Fig. 11. A window-sequence generator 134 and a t/f-analysis module 135 implement the t/f-transform unit 111 of Fig. 11.

Normally, the frequency bins of the underlying time/frequency-representation are grouped into parametric bands. The spacing of the bands resembles that of the critical bands in the human auditory system. Furthermore, multiple t/f-representation frames can be grouped into a parameter frame. Both of these operations provide a reduction in the amount of required side information with the cost of modeling inaccuracies.

As described in the SAOC standard, the OLDs and IOCs are used to calculate the un-mixing matrix **G = ED\*J,**

$$\mathbf{E}(i, j) = IOC_{i,j} \sqrt{OLD_i \, OLD_j}$$

where the elements of **E** are defined as approximates the object cross-correlation matrix, $i$ and $j$ are object indices, $\mathbf{J} \approx \mathbf{(DED^*)^{-1}}$. The un-mixing-matrix calculator 131 may be conducted to calculate the un-mixing matrix.

The un-mixing matrix is then linearly interpolated by the temporal interpolator 132 from the un-mixing matrix of the preceding frame over the parameter frame up to the parameter border on which the estimated values are reached, as per standard SAOC. This results into un-mixing matrices for each time-/frequency -analysis window and parametric band.

The parametric band frequency resolution of the un-mixing matrices is expanded to the resolution of the time/frequency-representation in that analysis window by the window-frequency-resolution-adaptation unit 133. When the interpolated un-mixing matrix for parametric band $b$ in a time-frame is defined as G(b), the same un-mixing coefficients are used for all the frequency bins inside that parametric band.

The window-sequence generator 134 is configured to use the parameter set range information from the PSI to determine an appropriate windowing sequence for analyzing the input downmix audio signal. The main requirement is that when there is a parameter set border in the PSI, the cross-over point between consecutive analysis windows should match it. The windowing determines also the frequency resolution of the data within each window (used in the un-mixing data expansion, as described earlier).

The windowed data is then transformed by the t/f-analysis module 135 into a frequency domain representation using an appropriate time-frequency transform, e.g., Discrete Fourier Transform (DFT), Complex Modified Discrete Cosine Transform (CMDCT), or Oddly stacked Discrete Fourier Transform (ODFT).

Finally, an un-mixing unit 136 applies the per-frame per-frequency bin un-mixing matrices on the spectral representation of the downmix signal **X** to obtain the parametric renderings **Y.** The output channel *j* is a linear combination of the downmix channels

$$\mathbf{Y}_j = \sum_i \mathbf{G}_{j,i} \mathbf{X}_i .$$

The quality that can be obtained with this process is for most of the purposes perceptually indistinguishable from the result obtained with a standard SAOC decoder.

It should be noted that the above text describes reconstruction of individual objects, but in standard SAOC the rendering is included in the un-mixing matrix, i.e., it is included in parametric interpolation. As a linear operation, the order of the operations does not matter, but the difference is worth noting.

In the following, decoding of enhanced SAOC bit streams with an enhanced decoder is described.

The main functionality of the enhanced SAOC decoder is already described earlier in decoding of standard SAOC bit streams. This section will detail how the introduced enhanced SAOC enhancements in the PSI can be used for obtaining a better perceptual quality.

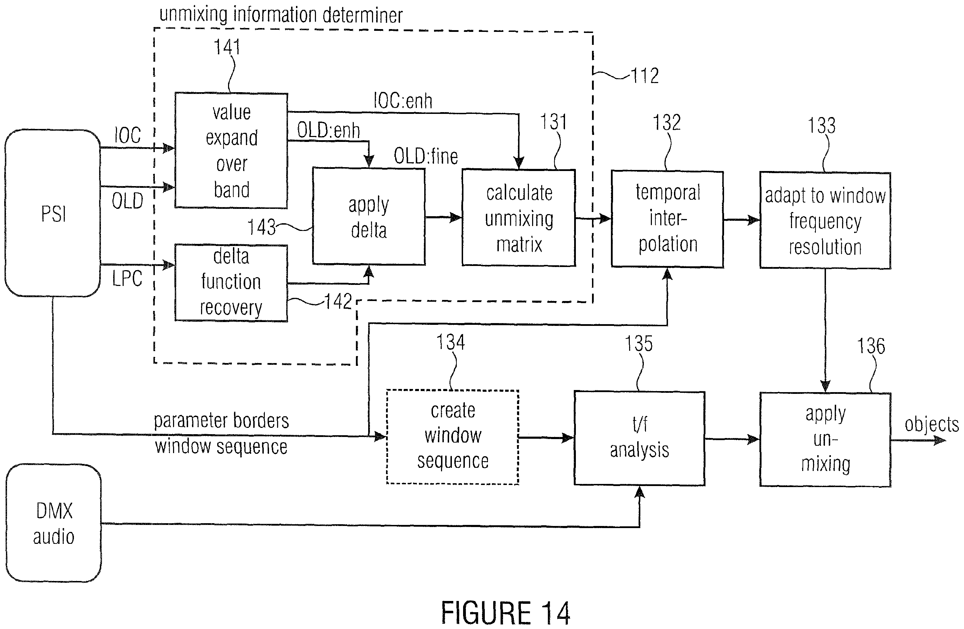

Fig. 14 depicts the main functional blocks of the decoder according to an embodiment illustrating the decoding of the frequency resolution enhancements. Bold black functional blocks (141, 142, 143) indicate the main part of the inventive processing. A value-expand-over-band unit 141, a delta-function-recovery unit 142, a delta-application unit 143, an un-mixing-matrix calculator 131, a temporal interpolator 132, and a window-frequency-resolution-adaptation unit 133 implement the functionality of the enhanced PSI-decoding unit 117 and of the un-mixing-matrix generator 118 of Fig. 11.

The decoder of Fig. 14 comprises an un-mixing-information determiner 112. Inter alia, the un-mixing-information determiner 112 comprises the delta-function-recovery unit 142 and the delta-application unit 143. The first parametric information comprises a plurality of parametric values depending on the at least one audio object signal, for example, object level difference values. The second parametric information comprises a correction factor parameterization. The delta-function-recovery unit 142 is configured to invert the correction factor parameterization to obtain a delta function. The delta-application unit 143 is configured to apply the delta function on the parametric values, e.g., on the object level difference values, to determine the un-mixing information. In an embodiment, the correction factor parameterization comprises a plurality of linear prediction coefficients, and the delta-function-recovery unit 142 is configured to invert the correction factor parameterization by generating a plurality of correction factors depending on the plurality of linear prediction coefficients, and is configured to generate the delta function based on the plurality of correction factors.

For example, at first, the value-expand-over-band unit 141 adapts the OLD and IOC values for each parametric band to the frequency resolution used in the enhancements, e.g., to 1024 bins. This is done by replicating the value over the frequency bins that correspond to the parametric band. This results into new OLDs $OLD_i^{enh}(f) = \mathbf{K}(f,b)OLD_i(b)$ and IOCs $IOC_{i,j}^{enh}(f) = \mathbf{K}(f,b)IOC_{i,j}(b)$ . $K(f,b)$ is a kernel matrix defining the assignment of frequency bins *f* into parametric bands *b*.

Parallel to this, the delta-function-recovery unit 142 inverts the correction factor parameterization to obtain the delta function $\mathbf{C}_i^{rec}(f)$ of the same size as the expanded OLD and IOC.

Then, the delta-application unit 143 applies the delta on the expanded OLD values, and the obtained fine resolution OLD values are obtained by $OLD_i^{fine}(f) = \mathbf{C}_i^{rec}(f)OLD_i^{enh}(f) .$

In a particular embodiment, the calculation of un-mixing matrices, may, for example, be done by the un-mixing-matrix calculator 131 as with decoding standard SAOC bit stream: $\mathbf{G}(f) = \mathbf{E}(f)\mathbf{D}^*(f)\mathbf{J}(f)$, with

$$\mathbf{E}_{i,j}(f) = IOC_{i,j}^{enh}(f)\sqrt{OLD_i^{fine}(f)OLD_j^{fine}(f)} ,$$

and $\mathbf{J}(f) \approx (\mathbf{D}(f)\mathbf{E}(f)\mathbf{D}^*(f))^{-1}$. If wanted, the rendering matrix can be multiplied into the un-mixing matrix $\mathbf{G}(f)$. The temporal interpolation by the temporal interpolator 132 follows as per the standard SAOC.

As the frequency resolution in each window may be different (lower) from the nominal high frequency resolution, the window-frequency-resolution-adaptation unit 133 need to adapt the un-mixing matrices to match the resolution of the spectral data from audio to allow applying it. This can be made, e.g., by re-sampling the coefficients over the frequency axis to the correct resolution. Or if the resolutions are integer multiples, simply averaging from the high-resolution data the indices that correspond to one frequency bin in the lower resolution

$$\mathbf{G}^{low}(b) = 1/\|b\| \sum_{f \in b} \mathbf{G}(f) .$$

The windowing sequence information from the bit stream can be used to obtain a fully complementary time-frequency analysis to the one used in the encoder, or the windowing sequence can be constructed based on the parameter borders, as is done in the standard SAOC bit stream decoding. For this, a window-sequence generator 134 may be employed.

The time-frequency analysis of the downmix audio is then conducted by a t/f-analysis module 135 using the given windows.

Finally, the temporally interpolated and spectrally (possibly) adapted un-mixing matrices are applied by an un-mixing unit 136 on the time-frequency representation of the input audio, and the output channel $j$ can be obtained as a

$$\mathbf{Y}_j(f) = \sum_i \mathbf{G}_{j,i}^{low}(f)\mathbf{X}_i(f).$$

linear combination of the input channels

In the following, particular aspects of embodiments are described.

In an embodiment, the delta-modeling unit 109 of Fig. 10 is configured to determine linear prediction coefficients from a plurality of correction factors (*delta*) by conducting a linear prediction.

Now, the estimation process of the correction factor, *delta,* and a possible modeling alternative using linear prediction coefficients (LPC) according to such an embodiment is described.

At first, delta estimation according to an embodiment is described.

The input to the estimation consists of the estimated fine-resolution power spectral profiles over the parameter block and from the coarse reconstruction of the power spectral profile based on the OLD and NRG parameters. The fine power spectrum profiles are calculated in the following manner. $\mathbf{S}_i(f,n)$ is the complex spectrum of the $i$ th object with f being the frequency bin index and $0 \leq n \leq N$ -1 being the temporal window index in the modeling block of the length $N$ . The fine-resolution power spectrum is then

$$\mathbf{P}_i(f) = \frac{1}{N}\sum_{n=0}^{N-1}\mathbf{S}_i(f,n)\mathbf{S}_i^*(f,n).$$

The coarse reconstruction is calculated from the (de-quantized) OLDs and NRGs by

$$\mathbf{Z}_i(f) = \mathbf{K}(f,b)OLD_i(b)NRG_i(b),$$

where K($f,b$) is the kernel matrix defining the assignment of frequency bins $f$ into parametric bands $b$.

Two signals with differing spectral properties will be used as examples in this section: the first one is (pink) noise with practically flat spectrum (ignoring the spectral tilt), and the second is a tone from the instrument glockenspiel which has a highly tonal, i.e., peaky, spectrum.

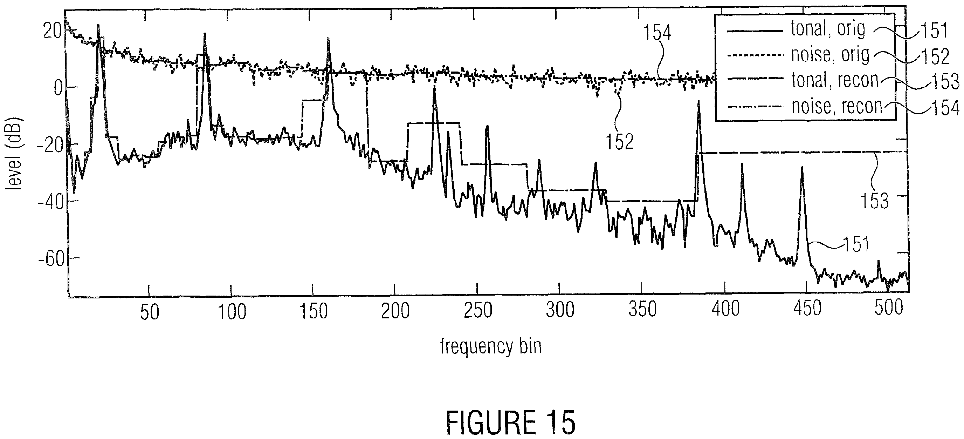

Fig. 15 illustrates the power spectra of a tonal and a noise signal. Their high-resolution power spectra ("orig") and the corresponding rough reconstructions based on OLDs and NRG ("recon"). In particular, Fig. 15 illustrates the fine and coarse power spectra of both of the signals. More particularly, the power spectra of an original tonal signal 151 and an original noise signal 152, and the reconstructed power spectra of the tonal signal 153 and the noise signal 154 are shown. It should be noted that, in the following figures, for signals 153 and 154 rather the scale factors (reconstructed power spectra parameter) and not the fully reconstructed signals are sketched.

It can be quickly noticed, the average difference between the fine and coarse value are rather small in the case of the noise signal, while the differences are very large in the tonal signal. These differences cause perceptual degradations in the parametric reconstruction of all objects.

The correction factor is obtained by dividing the fine-resolution curve by the coarse reconstruction curve:

$$\mathbf{C}_i(f) = \mathbf{P}_i(f)/\mathbf{Z}_i(f).$$

This allows recovering a multiplicative factor that can be applied on the rough reconstruction to obtain the fine-resolution curve:

$$\mathbf{P}_i^{rec}(f) = \mathbf{Z}_i(f)\mathbf{C}_i(f).$$

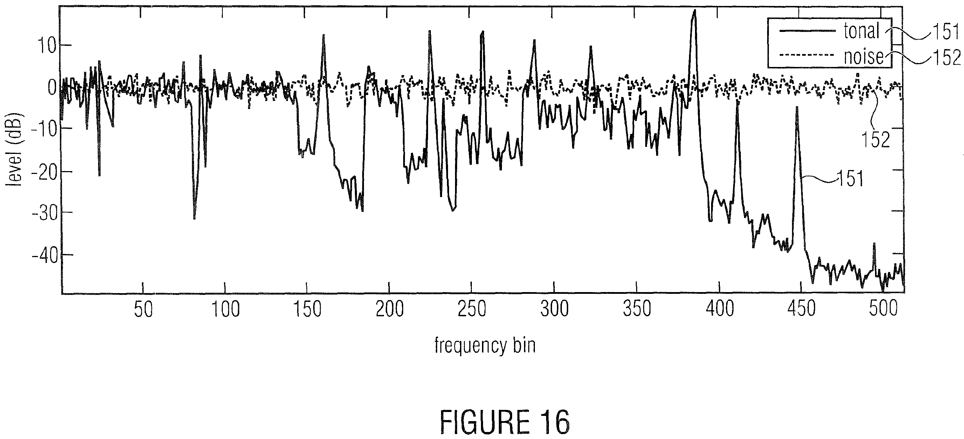

Fig. 16 illustrates the modification for both example signals, in particular the correction factors for the example signals. In particular, the correction factors for the tonal signal 151 and the noise signal 152 are shown.

In the following, delta modeling is described.

The correction curve **C** is assigned into one or more modeling blocks over the frequency axis. A natural alternative is to use the same parameter band definitions as are used for the standard SAOC PSI. The modeling is then done for each block separately with the following steps:

1. The spectral correction factor **C** is transformed to time domain autocorrelation sequence with Inverse Discrete Fourier Transform (IDFT).
When the length of the modeling block is odd, the pseudo-spectrum to be transformed is defined as

$$\mathbf{R}(l) = \begin{cases} \mathbf{C}(l), & \text{when } 0 \leq l \leq N-1 \\ \mathbf{C}(2N-2-l), & \text{when } N \leq l \leq 2N-3 \end{cases}.$$

When the modeling block is even, the pseudo-spectrum is defined as

$$\mathbf{R}(l) = \begin{cases} \mathbf{C}(l), & \text{when } 0 \leq l \leq N-1 \\ \mathbf{C}(2N-1-l), & \text{when } N \leq l \leq 2N-2 \end{cases}.$$

The transform result is then $r(t) = \text{IDFT}(\mathbf{R}(l))$.

2. The result is truncated into the first half: $\begin{cases} 0 \leq t \leq N-2, & \text{when } N \text{ is odd} \\ 0 \leq t \leq N-1, & \text{when } N \text{ is even} \end{cases}$

3. Levinson-Durbin recursions are applied on the auto-correlation sequence $r(t)$ to get the reflection coefficients **k** and modeling residual variances e for increasing model orders.

4. Optional: Based on modeling residual variance **e,** omit the entire modeling (as no gain was obtained) or select an appropriate order.

5. The model parameters are quantized for transmission.

It is possible to make a decision if the delta should be transmitted for each t-f tile (standard parametric band defining the frequency range and the parameter block the temporal range) independently. The decision can be made based on, for example,

- Inspecting the delta modeling residual energy. If the modeling residual energy does not exceed a certain threshold, the enhancement information is not transmitted.

- Measuring the "spikiness"/un-flatness of the fine-resolution modeled parametric description, the delta modeling, or the power spectral envelope of the audio object signal. Depending on the measured value the delta modeling parameters, which describe the fine spectral resolution, are transmitted or not, or computed at all dependent on the un-flatness of the power spectral envelope of the audio object signal). Appropriate measures are for example the spectral crest factor, the spectral flatness measure, or the minimum-maximum ratio.

- The perceptual quality of the reconstruction obtained. The encoder calculates the rendering reconstructions with and without the enhancements, and determines the quality gain for each enhancement. Then the point of appropriate balance between the modeling complexity and the quality gain is located, and the indicated enhancements are transmitted. For example, a perceptually weighted distortion to signal -ratio or enhanced perceptual measures can be used for the decision. The decision can be made for each (coarse) parametric band separately (i.e., local quality optimization), but also under consideration of adjacent bands to account for signal distortions caused by time- and frequency-variant manipulation of the time-frequency coefficients (i.e., global quality optimization).

Now, delta reconstruction and application is described.
The reconstruction of the correction curve follows the steps:

1. The received reflection coefficients **k**(a vector of the length *L*-1) are de-quantized and transformed into IIR-filter coefficients **a** of the length *L*, in pseudo code syntax (where the function X = diag(x) outputs a matrix *X* with the diagonal elements of *X* being *x* and all non-diagonal elements of *X* being zero):

```
A = diag(k)
for ii=1 to L
          for l=1 to ii-1
               A(l,ii) = A(l,ii-1) + k(ii)*A(ii-1,ii-1)
          end
end
a = [1; A(1 to end,end)]
```

2. The frequency response **h**(*n*) of the resulting filter **a** is calculated with

$$\mathbf{h}(n) = 1 / \sum_{l=0}^{L-1} \mathbf{a}(l) \exp\left(-in2\pi / N\right),$$

where *i* denotes the imaginary unit $i = \sqrt{-1}$ .

3. The correction function reconstruction is obtained from this by $\mathbf{C}^{raw}(n) = \mathbf{h}(n)\mathbf{h}^*(n)$.

4. The response is normalized to have a unity mean, so that the overall energy of the modeled block does not change

$$\mathbf{C}^{rec}(n) = \mathbf{C}^{raw}(n) / \sum_{n=0}^{N-1} \mathbf{C}^{raw}(n).$$

5. The correction factors are applied on OLDs, that have been extended to the fine resolution

$$OLD_i^{fine}(f) = \mathbf{C}_i^{rec}(f)\mathbf{K}(f,b)OLD_i(b).$$ Note, that in the absolute energies can be ignored as they would be cancelled in the further calculations.

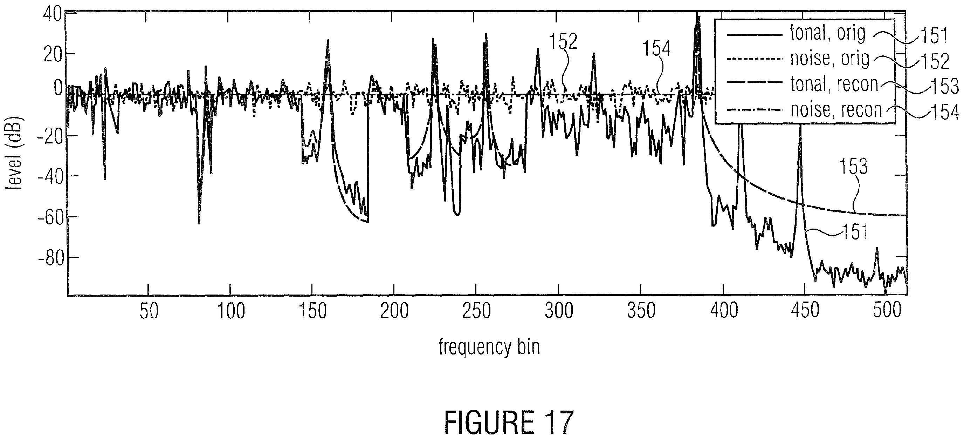

Fig. 17 illustrates the original correction factors and the reduced-order LPC-based approximations (after the modeling) for both of the example signals. In particular, the original correction factors of the tonal signal 151, the original noise signal 152, and the reconstructed correction factor estimates of the tonal signal 153 and the noise signal 154 are shown.

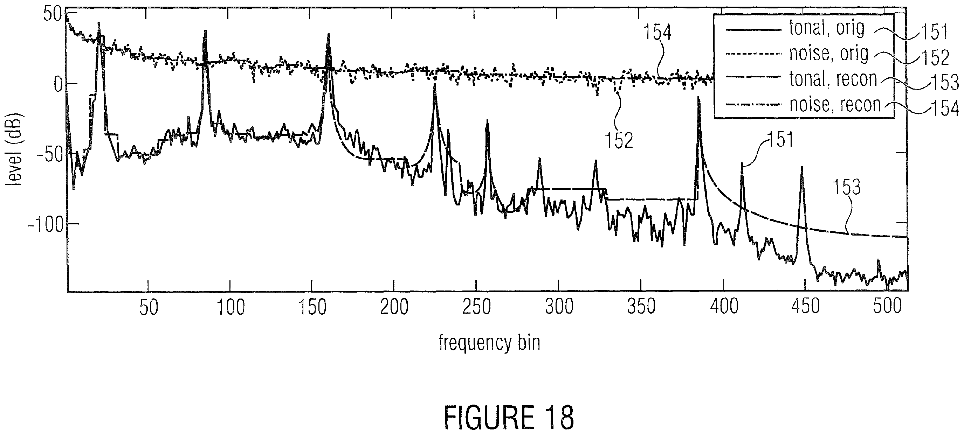

Fig. 18 illustrates the result of applying the modeled correction factors on the rough reconstructions illustrated in Fig. 15. In particular, the power spectra of the original tonal signal 151 and the original noise signal 152, and the reconstructed power spectra estimates of the tonal signal 153 and the noise signal 154 are shown. These curves can now be used instead of OLDs in the following calculations, in particular, the reconstructed fine-resolution power spectra after applying the modeled correction factors. Here, the absolute energy information is included to make the comparison better visible, but the same principle works also without them.

The inventive method and apparatus alleviate the aforementioned drawbacks of the state of the art SAOC processing using a filter bank or time-frequency transform with a high frequency resolution and providing an efficient parameterization of the additional information. Furthermore, it is possible to transmit this additional information in such a way that the standard SAOC-decoders can decode the backwards compatible portion of the information at a quality obtainable comparable to the one obtained using a standard-conformant SAOC encoder, and still allow the enhanced decoders to utilize the additional information for a better perceptual quality. Most importantly, the additional information can be represented in a very compact manner for efficient transmission or storage.

The presented inventive method can be applied on any SAOC scheme. It can be combined with any current and also future audio formats. The inventive method allows for enhanced perceptual audio quality in SAOC applications by a two-level representation of spectral side information.

The same idea can be used also in conjunction with MPEG Surround when replacing the concept of OLDs with channel-level differences (CLDs).

An audio encoder or method of audio encoding or related computer program as described above is provided. Moreover, an audio encoder or method of audio decoding or related computer program as described above is provided. Furthermore, an encoded audio signal or storage medium having stored the encoded audio signal as described above is provided.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The inventive decomposed signal can be stored on a digital storage medium or can be transmitted on a transmission medium such as a wireless transmission medium or a wired transmission medium such as the Internet.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a non-transitory data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

References

[BCC]   C. Faller and F. Baumgarte, "Binaural Cue Coding - Part II: Schemes and applications," IEEE Trans. on Speech and Audio Proc., vol. 11, no. 6, Nov. 2003.

[JSC]   C. Faller, "Parametric Joint-Coding of Audio Sources", 120th AES Convention, Paris, 2006.

[SAOC1]   J. Herre, S. Disch, J. Hilpert, O. Hellmuth: "From SAC To SAOC - Recent Developments in Parametric Coding of Spatial Audio", 22nd Regional UK AES Conference, Cambridge, UK, April 2007.

[SAOC2]   J. Engdegård, B. Resch, C. Falch, O. Hellmuth, J. Hilpert, A. Hölzer, L. Terentiev, J. Breebaart, J. Koppens, E. Schuijers and W. Oomen: " Spatial Audio Object Coding (SAOC) - The Upcoming MPEG Standard on Parametric Object Based Audio Coding", 124th AES Convention, Amsterdam, 2008.

[SAOC]   ISO/IEC, "MPEG audio technologies - Part 2: Spatial Audio Object Coding (SAOC)," ISO/IEC JTC1/SC29/WG11 (MPEG) International Standard 23003-2:2010.

[AAC]   M .Bosi, K. Brandenburg, S. Quackenbush, L. Fielder, K. Akagiri, H. Fuchs, M. Dietz, "ISO/IEC MPEG-2 Advanced Audio Coding", J. Audio Eng. Soc, vol 45, no 10, pp. 789-814, 1997.

[1551]   M. Parvaix and L. Girin: "Informed Source Separation of underdetermined instantaneous Stereo Mixtures using Source Index Embedding", IEEE ICASSP, 2010.

(continued)

[ISS2] M. Parvaix, L. Girin, J.-M. Brossier: "A watermarking-based method for informed source separation of audio signals with a single sensor", IEEE Transactions on Audio, Speech and Language Processing, 2010.

[ISS3] A. Liutkus and J. Pinel and R. Badeau and L. Girin and G. Richard: "Informed source separation through spectrogram coding and data embedding", Signal Processing Journal, 2011.

[ISS4] A. Ozerov, A. Liutkus, R. Badeau, G. Richard: "Informed source separation: source coding meets source separation", IEEE Workshop on Applications of Signal Processing to Audio and Acoustics, 2011.

[ISS5] S. Zhang and L. Girin: "An Informed Source Separation System for Speech Signals", INTERSPEECH, 2011.

[ISS6] L. Girin and J. Pinel: "Informed Audio Source Separation from Compressed Linear Stereo Mixtures", AES 42nd International Conference: Semantic Audio, 2011.

[ISS7] A. Nesbit, E. Vincent, and M. D. Plumbley: "Benchmarking flexible adaptive time-frequency transforms for underdetermined audio source separation", IEEE International Conference on Acoustics, Speech and Signal Processing, pp. 37-40, 2009.

## Claims

1. A decoder for generating an un-mixed audio signal comprising a plurality of un-mixed audio channels, wherein the decoder comprises:

   an un-mixing-infonnation determiner (112) for determining un-mixing information by receiving first parametric side information on the at least one audio object signal and second parametric side information on the at least one audio object signal, wherein the frequency resolution of the second parametric side information is higher than the frequency resolution of the first parametric side information, and
   an un-mix module (113) for applying the un-mixing information on a downmix signal, indicating a downmix of at least one audio object signal, to obtain an un-mixed audio signal comprising the plurality of un-mixed audio channels,
   wherein the un-mixing-information determiner (112) is configured to determine the un-mixing information by modifying the first parametric information and the second parametric information to obtain modified parametric information, such that the modified parametric information has a frequency resolution which is higher than the first frequency resolution.

2. A decoder according to claim 1,
   wherein the decoder further comprises a first transform unit (111) for transforming a downmix input, being represented in a time domain, to obtain the downmix signal, being represented in a time-frequency domain, and
   wherein the decoder comprises a second transform unit (114) for transforming the un-mixed audio signal from the time-frequency domain to the time domain.

3. A decoder according to claim 1 or 2, wherein the un-mixing-information determiner (112) is configured to determine the un-mixing information by combining the first parametric information and the second parametric information to obtain the modified parametric information, such that the modified parametric information has a frequency resolution which is equal to the second frequency resolution.

4. A decoder according to one of the preceding claims,
   wherein the first parametric information comprises a plurality of first parameter values, wherein the second parametric information comprises a plurality of second parameter values,
   wherein the un-mixing-information determiner (112) comprises a frequency-resolution-conversion subunit (122) and a combiner (124),
   wherein the frequency-resolution-conversion unit (112) is configured to generate additional parameter values, wherein the first parameter values and the additional parameter values together form a plurality of first processed parameter values, and
   wherein the combiner (124) is configured to combine the first processed parameter values and the second parameter values to obtain a plurality of modified parameter values as the modified parametric information.

**5.** A decoder according to one of the preceding claims,
wherein the un-mixing-information determiner (112) comprises a delta-function-recovery unit (142) and a delta-application unit (143),
wherein the first parametric information comprises a plurality of parametric values depending on the at least one audio object signal, and wherein the second parametric information comprises a correction factor parameterization,
wherein the delta-function-recovery unit (142) is configured to invert the correction factor parameterization to obtain a delta function, and
wherein the delta-application unit (143) is configured to apply the delta function on the parametric values to determine the un-mixing information.

**6.** A decoder according to claim 5,
wherein the correction factor parameterization comprises a plurality of linear prediction coefficients,
wherein the delta-function-recovery unit (142) is configured to invert the correction factor parameterization by generating a plurality of correction factors depending on the plurality of linear prediction coefficients, and
wherein the delta-function-recovery unit (142) is configured to generate the delta function based on the plurality of correction factors.

**7.** A decoder according to one of the preceding claims,
wherein the decoder further comprises an un-mixing-matrix generator (118) for generating an un-mixing matrix depending on the first parametric side information, depending on the second parametric side information, and depending on rendering information, and
wherein the un-mix module (113) is configured to apply the un-mixing matrix on the transformed downmix to obtain the un-mixed audio signal.

**8.** A decoder according to one of the preceding claims,
wherein the un-mix module (113) comprises a decorrelation unit (119) and an un-mixing unit (110),
wherein the decorrelation unit (119) is configured to conduct decorrelation on the transformed downmix to obtain a decorrelation result,
and wherein the un-mixing unit (110) is configured to employ the decorrelation result to obtain the un-mixed audio signal.

**9.** An encoder for encoding one or more input audio object signals, comprising:

a downmix unit (91) for downmixing the one or more input audio object signals to obtain one or more downmix signals, and
a parametric-side-information generator (93) for generating first parametric side information on the at least one audio object signal and second parametric side information on the at least one audio object signal, such that the frequency resolution of the second parametric side information is higher than the frequency resolution of the first parametric side information,
wherein the parametric-side-information generator (93) is configured to generate the first parametric side information and the second parametric side information so that the one or more input audio object signals are decodable from the one or more downmix signals using the first parametric side information together with the second parametric side information.

**10.** An encoder according to claim 9,
wherein the encoder further comprises a transform unit (92) for transforming the one or more input audio object signals from a time domain to a time-frequency domain to obtain one or more transformed audio object signals, and
wherein the parametric-side-information generator (93) is configured to generate the first parametric side information and the second parametric side information based on the one or more transformed audio object signals.

**11.** An encoder according to claim 10,
wherein the transform unit (92) is configured to transform the one or more input audio object signals from the time domain to the time-frequency domain depending on a window length of a signal transform block comprising signal values of at least one of the one or more input audio object signals,
wherein the transform unit (92) comprises a transient-detection unit (101) for determining a transient detection result indicating whether a transient is present in one or more of the at least one audio object signals, wherein a transient indicates a signal change in one or more of the at least one audio object signals, and
wherein the transform unit (92) further comprises a window sequence unit (102) for determining the window length depending on the transient detection result.

**12.** An encoder according to one of claims 9 to 11, wherein the encoder further comprises a delta-estimation unit (108) for estimating a plurality of correction factors based on a plurality of parametric values depending on the at least one audio object signal to obtain the second parametric side information.

**13.** An encoder according to claim 12, wherein the encoder further comprises a delta modelling unit (109) for determining linear prediction coefficients from the plurality of correction factors by conducting a linear prediction.

**14.** A system comprising:

an encoder (61) according to one of claims 9 to 13 for encoding one or more input audio object signals by obtaining one or more downmix signals indicating a downmix of one or more input audio object signals, by obtaining first parametric side information on the at least one audio object signal, and by obtaining second parametric side information on the at least one audio object signal, wherein the frequency resolution of the second parametric side information is higher than the frequency resolution of the first parametric side information, and

a decoder (62) according to one of claims 1 to 8 for generating an un-mixed audio signal based on the one or more downmix signals, and based on the first parametric side information and the second parametric side information.

**15.** A method for generating an un-mixed audio signal comprising a plurality of un-mixed audio channels, wherein the method comprises:

determining un-mixing information by receiving first parametric side information on the at least one audio object signal and second parametric side information on the at least one audio object signal, wherein the frequency resolution of the second parametric side information is higher than the frequency resolution of the first parametric side information, and

applying the un-mixing information on a downmix signal, indicating a downmix of at least one audio object signal, to obtain an un-mixed audio signal comprising the plurality of un-mixed audio channels,

wherein determining the un-mixing information comprises modifying the first parametric information and the second parametric information to obtain modified parametric information, such that the modified parametric information has a frequency resolution which is higher than the first frequency resolution.

**16.** A method for encoding one or more input audio object signals, comprising:

downmixing the one or more input audio object signals to obtain one or more downmix signals, and generating first parametric side information on the at least one audio object signal and second parametric side information on the at least one audio object signal, such that the frequency resolution of the second parametric side information is higher than the frequency resolution of the first parametric side information, wherein the first parametric side information and the second parametric side information are generated so that the one or more input audio object signals are decodable from the one or more downmix signals using the first parametric side information together with the second parametric side information.

**17.** A computer program for implementing the method of claim 15 or 16 when being executed on a computer or signal processor.

**Patentansprüche**

**1.** Ein Decodierer zum Erzeugen eines entmischten Audiosignals, das eine Mehrzahl von entmischten Audiokanälen aufweist, wobei der Decodierer folgende Merkmale aufweist:

eine Entmischungsinformationsbestimmungseinrichtung (112) zum Bestimmen von Entmischungsinformationen durch Empfangen erster parametrischer Nebeninformationen über das zumindest eine Audioobjektsignal und zweiter parametrischer Nebeninformationen über das zumindest eine Audioobjektsignal, wobei die Frequenzauflösung der zweiten parametrischen Nebeninformationen höher ist als die Frequenzauflösung der ersten parametrischen Nebeninformationen und

ein Entmischungsmodul (113) zum Anlegen der Entmischungsinformationen an ein Abwärtsmischsignal, das ein Abwärtsmischen von zumindest einem Audioobjektsignal anzeigt, um ein entmischtes Audiosignal zu erhalten, das die Mehrzahl von entmischten Audiokanälen aufweist,

wobei die Entmischungsinformationsbestimmungseinrichtung (112) konfiguriert ist, um die Entmischungsinformationen durch Modifizieren der ersten parametrischen Informationen und der zweiten parametrischen Informationen zu bestimmen, um modifizierte parametrische Informationen zu erhalten, so dass die modifizierten parametrischen Informationen eine Frequenzauflösung aufweisen, die höher ist als die erste Frequenzauflösung.

2. Ein Decodierer gemäß Anspruch 1,

wobei der Decodierer ferner eine erste Transformationseinheit (111) aufweist zum Transformieren einer Abwärtsmischeingabe, die in einem Zeitbereich dargestellt ist, um das Abwärtsmischsignal zu erhalten, das in einem Zeit-Frequenz-Bereich dargestellt ist und

wobei der Decodierer eine zweite Transformationseinheit (114) aufweist zum Transformieren des entmischten Audiosignals von dem Zeit-Frequenz-Bereich in den Zeitbereich.

3. Ein Decodierer gemäß Anspruch 1 oder 2,

bei dem die Entmischungsinformationsbestimmungseinrichtung (112) konfiguriert ist, um die Entmischungsinformationen durch Kombinieren der ersten parametrischen Informationen und der zweiten parametrischen Informationen zu bestimmen, um die modifizierten parametrischen Informationen zu erhalten, so dass die modifizierten parametrischen Informationen eine Frequenzauflösung aufweisen, die gleich der zweiten Frequenzauflösung ist.

4. Ein Decodierer gemäß einem der vorhergehenden Ansprüche,

bei dem die ersten parametrischen Informationen eine Mehrzahl von ersten Parameterwerten aufweisen, wobei die zweiten parametrischen Informationen eine Mehrzahl von zweiten Parameterwerten aufweisen,

wobei die Entmischungsinformationsbestimmungseinrichtung (112) eine Frequenzauflösungsumwandlungsuntereinheit (122) und einen Kombinierer (124) aufweist,

wobei die Frequenzauflösungsumwandlungsuntereinheit (112) konfiguriert ist, um zusätzliche Parameterwerte zu erzeugen, wobei die ersten Parameterwerte und die zusätzlichen Parameterwerte zusammen eine Mehrzahl von ersten verarbeiteten Parameterwerten bilden und

wobei der Kombinierer (124) konfiguriert ist, um die ersten verarbeiteten Parameterwerte und die zweiten Parameterwerte zu kombinieren, um eine Mehrzahl von modifizierten Parameterwerten als die modifizierten parametrischen Informationen zu erhalten.

5. Ein Decodierer gemäß einem der vorhergehenden Ansprüche,

bei dem die Entmischungsinformationsbestimmungseinrichtung (112) eine Delta-Funktion-Rückgewinnungseinheit (142) und eine Delta-Anwendungseinheit (143) aufweist,

wobei die ersten parametrischen Informationen eine Mehrzahl von parametrischen Werten aufweisen, in Abhängigkeit von dem zumindest einen Audioobjektsignal, und wobei die zweiten parametrischen Informationen eine Korrekturfaktorparametrisierung aufweisen,

wobei die Delta-Funktion-Rückgewinnungseinheit (142) konfiguriert ist, um die Korrekturfaktorparametrisierung zu invertieren, um eine Delta-Funktion zu erhalten, und

wobei die Delta-Anwendungseinheit (143) konfiguriert ist, um die Delta-Funktion an die parametrischen Werte anzulegen, um die Entmischungsinformationen zu bestimmen.

6. Ein Decodierer gemäß Anspruch 5,

bei dem die Korrekturfaktorparametrisierung eine Mehrzahl von Lineare-Prädiktion-Koeffizienten aufweist,

wobei die Delta-Funktion-Rückgewinnungseinheit (142) konfiguriert ist, um die Korrekturfaktorparametrisierung zu invertieren durch Erzeugen einer Mehrzahl von Korrekturfaktoren in Abhängigkeit von der Mehrzahl von Lineare-Prädiktion-Koeffizienten und

wobei die Delta-Funktion-Rückgewinnungseinheit (142) konfiguriert ist, um die Delta-Funktion basierend auf der Mehrzahl von Korrekturfaktoren zu erzeugen.

7. Ein Decodierer gemäß einem der vorhergehenden Ansprüche,

wobei der Decodierer ferner einen Entmischungsmatrixgenerator (118) aufweist zum Erzeugen einer Entmischungsmatrix in Abhängigkeit von den ersten parametrischen Nebeninformationen, in Abhängigkeit von den zweiten parametrischen Nebeninformationen und in Abhängigkeit von Aufbereitungsinformationen und wobei das Entmischungsmodul (113) konfiguriert ist, um die Entmischungsmatrix an die transformierte Abwärtsmischung anzulegen, um das entmischte Audiosignal zu erhalten,

8. Ein Decodierer gemäß einem der vorhergehenden Ansprüche,
bei dem das Entmischungsmodul (113) eine Dekorrelationseinheit (119) und eine Entmischungseinheit (110) aufweist,
wobei die Dekorrelationseinheit (119) konfiguriert ist, um an der transformierten Abwärtsmischung eine Dekorrelation durchzuführen, um ein Dekorrelationsergebnis zu erhalten,
und wobei die Entmischungseinheit (110) konfiguriert ist, um das Dekorrelationsergebnis zu verwenden, um das entmischte Audiosignal zu erhalten.

9. Ein Codierer zum Codieren eines oder mehrerer Eingabeaudioobjektsignale, der folgende Merkmale aufweist:

eine Abwärtsmischeinheit (91) zum Abwärtsmischen des einen oder der mehreren Eingabeaudioobjektsignale, um ein oder mehrere Abwärtsmischsignale zu erhalten und
einen Parametrische-Nebeninformationen-Generator (93) zum Erzeugen erster parametrischer Nebeninformationen über das zumindest eine Audioobjektsignal und zweiter parametrischer Nebeninformationen über das zumindest eine Audioobjektsignal, so dass die Frequenzauflösung der zweiten parametrischen Nebeninformationen höher ist als die Frequenzauflösung der ersten parametrischen Nebeninformationen,
wobei der Parametrische-Nebeninformationen-Generator (93) konfiguriert ist, um die ersten parametrischen Nebeninformationen und die zweiten parametrischen Nebeninformationen zu erzeugen, so dass das eine oder die mehreren Eingabeaudioobjektsignale von dem einen oder den mehreren Abwärtsmischsignalen decodierbar sind unter Verwendung der ersten parametrischen Nebeninformationen zusammen mit den zweiten parametrischen Nebeninformationen.

10. Ein Codierer gemäß Anspruch 9 ,
wobei der Codierer ferner eine Transformationseinheit (92) aufweist zum Transformieren des einen oder der mehreren Eingabeaudioobjektsignale von einem Zeitbereich in einen Zeit-Frequenz-Bereich, um ein oder mehrere transformierte Audioobjektsignale zu erhalten und
wobei der Parametrische-Nebeninformationen-Generator (93) konfiguriert ist, um die ersten parametrischen Nebeninformationen und die zweiten parametrischen Nebeninformationen basierend auf dem einen oder den mehreren transformierten Audioobjektsignalen zu erzeugen.

11. Ein Codierer gemäß Anspruch 10,
bei dem die Transformationseinheit (92) konfiguriert ist, um das eine oder die mehreren Eingabeaudioobjektsignale von dem Zeitbereich in den Zeit-Frequenz-Bereich zu transformieren in Abhängigkeit von einer Fensterlänge eines Signaltransformationsblocks, der Signalwerte von zumindest einem des einen oder der mehreren Eingabeaudioobjektsignale aufweist,
wobei die Transformationseinheit (92) eine Transientenerfassungseinheit (101) zum Bestimmen eines Transientenerfassungsergebnisses aufweist, das anzeigt, ob in einem oder mehreren des zumindest einem Audioobjektsignals eine Transiente vorliegt, wobei eine Transiente eine Signaländerung in einem oder mehreren des zumindest einen Audioobjektsignals anzeigt und
wobei die Transformationseinheit (92) ferner eine Fenstersequenzeinheit (102) aufweist zum Bestimmen der Fensterlänge in Abhängigkeit von dem Transientenerfassungsergebnis.

12. Ein Codierer gemäß einem der Ansprüche 9 bis 11, wobei der Codierer ferner eine Delta-Schätzeinheit (108) aufweist zum Schätzen einer Mehrzahl von Korrekturfaktoren basierend auf einer Mehrzahl von parametrischen Werten in Abhängigkeit von dem zumindest einen Audioobjektsignal, um die zweiten parametrischen-Nebeninformationen zu erhalten.

13. Ein Codierer gemäß Anspruch 12, wobei der Codierer ferner eine Delta-Modellierungseinheit (109) aufweist zum Bestimmen von Lineare-Prädiktion-Koeffizienten von der Mehrzahl von Korrekturfaktoren durch Durchführen einer linearen Prädiktion.

14. Ein System, das folgende Merkmale aufweist:

einen Codierer (61) gemäß einem der Ansprüche 9 bis 13 zum Codieren eines oder mehrerer Eingabeaudioobjektsignale durch Erhalten eines oder mehrerer Abwärtsmischsignale, die ein Abwärtsmischen von einem oder mehreren Eingabeaudioobjektsignalen anzeigen, durch Erhalten erster parametrischer Nebeninformationen über das zumindest eine Audioobjektsignal und durch Erhalten zweiter parametrischer Nebeninformationen über das zumindest eine Audioobjektsignal, wobei die Frequenzauflösung der zweiten parametrischen Nebeninformationen höher ist als die Frequenzauflösung der ersten parametrischen Nebeninformationen und

einen Decodierer (62) gemäß einem der Ansprüche 1 bis 8 zum Erzeugen eines entmischten Audiosignals basierend auf dem einen oder den mehreren Abwärtsmischsignalen und basierend auf den ersten parametrischen Nebeninformationen und den zweiten parametrischen Nebeninformationen.

15. Ein Verfahren zum Erzeugen eines entmischten Audiosignals, das eine Mehrzahl von entmischten Audiokanälen aufweist, wobei das Verfahren folgende Schritte aufweist:

Bestimmen von Entmischungsinformationen durch Empfangen erster parametrischer Nebeninformationen über das zumindest eine Audioobjektsignal und zweiter parametrischer Nebeninformationen über das zumindest eine Audioobjektsignal, wobei die Frequenzauflösung der zweiten parametrischen Nebeninformationen höher ist als die Frequenzauflösung der ersten parametrischen Nebeninformationen und

Anlegen der Entmischungsinformationen an ein Abwärtsmischsignal, das ein Abwärtsmischen von zumindest einem Audioobjektsignal anzeigt, um ein entmischtes Audiosignal zu erhalten, das die Mehrzahl von entmischten Audiokanälen aufweist,

wobei das Bestimmen der Entmischungsinformationen ein Modifizieren der ersten parametrischen Informationen und der zweiten parametrischen Informationen aufweist, um modifizierte parametrische Informationen zu erhalten, so dass die modifizierten parametrischen Informationen eine Frequenzauflösung aufweisen, die höher ist die erste Frequenzauflösung.

16. Ein Verfahren zum Codieren eines oder mehrerer Eingabeaudioobjektsignale, das folgende Schritte aufweist:

Abwärtsmischen der einen oder der mehreren Eingabeaudioobjektsignale, um ein oder mehrere Abwärtsmischsignale zu erhalten und

Erzeugen erster parametrischer Nebeninformationen über das zumindest eine Audioobjektsignal und zweiter parametrischer Nebeninformationen über das zumindest eine Audioobjektsignal, so dass die Frequenzauflösung der zweiten parametrischen Nebeninformationen höher ist als die Frequenzauflösung der ersten parametrischen Nebeninformationen,

wobei die ersten parametrischen Nebeninformationen und die zweiten parametrischen Nebeninformationen erzeugt werden, so dass das eine oder die mehreren Eingabeaudioobjektsignale von dem einen oder den mehreren Abwärtsmischsignalen decodierbar sind unter Verwendung der ersten parametrischen Nebeninformationen zusammen mit den zweiten parametrischen Nebeninformationen.

17. Ein Computerprogramm zum Implementieren des Verfahrens gemäß Anspruch 15 oder 16, wenn dasselbe auf einem Computer oder Signalprozessor ausgeführt wird.

**Revendications**

1. Décodeur pour générer un signal audio non mélangé comprenant une pluralité de canaux audio non mélangés, dans lequel le décodeur comprend:

un déterminateur d'informations de démélange (112) destiné à déterminer les informations de démélange en recevant des premières informations latérales paramétriques sur l'au moins un signal d'objet audio et des deuxièmes informations latérales paramétriques sur l'au moins un signal d'objet audio, où la résolution de fréquence des deuxièmes informations latérales paramétriques est supérieure à la résolution de fréquence des premières informations latérales paramétriques, et

un module de démélange (113) destiné à appliquer les informations de démélange sur un signal de mélange vers le bas indiquant un mélange vers le bas d'au moins un signal d'objet audio, pour obtenir un signal audio non mélangé comprenant la pluralité de canaux audio non mélangés,

dans lequel le déterminateur d'informations de démélange (112) est configuré pour déterminer les informations de démélange en modifiant les premières informations paramétriques et les deuxièmes informations paramétriques pour obtenir des informations paramétriques modifiées, de sorte que les informations paramétriques modifiées présentent une résolution de fréquence qui est supérieure à la première résolution de fréquence.

2. Décodeur selon la revendication 1,

dans lequel le décodeur comprend par ailleurs une première unité de transformée (111) destinée à transformer une entrée de mélange vers le bas représentée dans un domaine temporel, pour obtenir le signal de mélange vers le bas représenté dans un domaine temps-fréquence, et

dans lequel le décodeur comprend une deuxième unité de transformée (114) destinée à transformer le signal audio non mélangé du domaine temps-fréquence au domaine temporel.

**3.** Décodeur selon la revendication 1 ou 2, dans lequel le déterminateur d'informations de démélange (112) est configuré pour déterminer les informations de démélange en combinant les premières informations paramétriques et les deuxièmes informations paramétriques pour obtenir des informations paramétriques modifiées, de sorte que les informations paramétriques modifiées présentent une résolution de fréquence qui est égale à la deuxième résolution de fréquence.

**4.** Décodeur selon l'une des revendications précédentes,
dans lequel les premières informations paramétriques comprennent une pluralité de premières valeurs de paramètre,
dans lequel les deuxièmes informations paramétriques comprennent une pluralité de deuxièmes valeurs de paramètre,
dans lequel le déterminateur d'informations de démélange (112) comprend une sous-unité de conversion de résolution de fréquence (122) et un combineur (124),
dans lequel l'unité de conversion de résolution de fréquence (112) est configurée pour générer des valeurs de paramètre additionnelles, où les premières valeurs de paramètre et les valeurs de paramètre additionnelles forment ensemble une pluralité de premières valeurs de paramètre traitées, et
dans lequel le combineur (124) est configuré pour combiner les premières valeurs de paramètre traitées et les deuxièmes valeurs de paramètre pour obtenir une pluralité de valeurs de paramètre modifiées comme informations paramétriques modifiées.

**5.** Décodeur selon l'une des revendications précédentes,
dans lequel le déterminateur d'informations de démélange (112) comprend une unité de récupération de fonction delta (142) et une unité d'application de delta (143),
dans lequel les premières informations paramétriques comprennent une pluralité de valeurs paramétriques en fonction de l'au moins un signal d'objet audio, et dans lequel les deuxièmes informations paramétriques comprennent un paramétrage de facteur de correction,
dans lequel l'unité de récupération de fonction delta (142) est configurée pour inverser le paramétrage du facteur de correction pour obtenir une fonction delta, et
dans lequel l'unité d'application de delta (143) est configurée pour appliquer la fonction delta aux valeurs paramétriques pour déterminer les informations de démélange.

**6.** Décodeur selon la revendication 5,
dans lequel le paramétrage de facteur de correction comprend une pluralité de coefficients de prédiction linéaire,
dans lequel l'unité de récupération de fonction delta (142) est configurée pour inverser le paramétrage de facteur de correction en générant une pluralité de facteurs de correction en fonction de la pluralité de coefficients de prédiction linéaire, et
dans lequel l'unité de récupération de fonction delta (142) est configurée pour générer la fonction delta sur base de la pluralité de facteurs de correction.

**7.** Décodeur selon l'une des revendications précédentes,
dans lequel le décodeur comprend par ailleurs un générateur de matrice de démélange (118) destiné à générer une matrice de démélange en fonction des premières informations latérales paramétriques, en fonction des deuxièmes informations latérales paramétriques, et en fonction des informations de rendu, et
dans lequel le module de démélange (113) est configuré pour appliquer la matrice de démélange sur le mélange vers le bas transformé pour obtenir le signal audio non mélangé.

**8.** Décodeur selon l'une des revendications précédentes,
dans lequel le module de démélange (113) comprend une unité de décorrélation (119) et une unité de démélange (110),
dans lequel l'unité de décorrélation (119) est configurée pour effectuer une décorrélation sur le mélange vers le bas transformé pour obtenir un résultat de décorrélation,
et dans lequel l'unité de démélange (110) est configurée pour utiliser le résultat de décorrélation pour obtenir le signal audio non mélangé.

**EP 2 904 609 B1**

9. Codeur pour coder un ou plusieurs signaux d'objet audio d'entrée, comprenant:

une unité de mélange vers le bas (91) destinée à mélanger vers le bas les un ou plusieurs signaux d'objet audio d'entrée pour obtenir un ou plusieurs signaux de mélange vers le bas, et

un générateur d'informations latérales paramétriques (93) destiné à générer des premières informations latérales paramétriques sur l'au moins un signal d'objet audio et des deuxièmes informations latérales paramétriques sur l'au moins un signal d'objet audio, de sorte que la résolution de fréquence des deuxièmes informations latérales paramétriques soit supérieure à la résolution de fréquence des premières informations latérales paramétriques,

dans lequel le générateur d'informations latérales paramétriques (93) est configuré pour générer les premières informations latérales paramétriques et les deuxièmes informations latérales paramétriques de sorte que les un ou plusieurs signaux d'objet audio d'entrée puissent être décodés à partir des un ou plusieurs signaux de mélange vers le bas à l'aide des premières informations latérales paramétriques ensemble avec les deuxièmes informations latérales paramétriques.

10. Codeur selon la revendication 9,
dans lequel le codeur comprend par ailleurs une unité de transformée (92) destinée à transformer les un ou plusieurs signaux d'objet audio d'entrée d'un domaine temporel à un domaine temps-fréquence pour obtenir un ou plusieurs signaux d'objet audio transformés, et

dans lequel le générateur d'informations latérales paramétriques (93) est configuré pour générer les premières informations latérales paramétriques et les deuxièmes informations latérales paramétriques sur base des un ou plusieurs signaux d'objet audio transformés.

11. Codeur selon la revendication 10,
dans lequel l'unité de transformée (92) est configurée pour transformer les un ou plusieurs signaux d'objet audio d'entrée du domaine temporel au domaine temps-fréquence en fonction d'une longueur de fenêtre d'un bloc de transformée de signal comprenant les valeurs de signal d'au moins un des un ou plusieurs signaux d'objet audio d'entrée,

dans lequel l'unité de transformée (92) comprend une unité de détection de transitoire (101) destinée à déterminer un résultat de détection de transitoire indiquant si un transitoire est présent dans un ou plusieurs des signaux d'objet audio, où un transitoire indique un changement de signal dans un ou plusieurs de l'au moins un signal d'objet audio, et

dans lequel l'unité de transformée (92) comprend par ailleurs une unité de séquence de fenêtre (102) destinée à déterminer la longueur de fenêtre en fonction du résultat de détection de transitoire.

12. Codeur selon l'une des revendications 9 à 11, dans lequel le codeur comprend par ailleurs une unité d'estimation de delta (108) destinée à estimer une pluralité de facteurs de correction sur base d'une pluralité de valeurs paramétriques en fonction de l'au moins un signal d'objet audio pour obtenir les deuxièmes informations latérales paramétriques.

13. Codeur selon la revendication 12, dans lequel le codeur comprend par ailleurs une unité de modélisation de delta (109) destinée à déterminer des coefficients de prédiction linéaire à partir de la pluralité de facteurs de correction en effectuant une prédiction linéaire.

14. Système comprenant:

un codeur (61) selon l'une des revendications 9 à 13 destiné à coder un ou plusieurs signaux d'objet audio d'entrée en obtenant un ou plusieurs signaux de mélange vers le bas indiquant un mélange vers le bas d'un ou plusieurs signaux d'objet audio d'entrée, en obtenant des premières informations latérales paramétriques sur l'au moins un signal d'objet audio et en obtenant des deuxièmes informations latérales paramétriques sur l'au moins un signal d'objet audio, où la résolution de fréquence des deuxièmes informations latérales paramétriques est supérieure à la résolution de fréquence des premières informations latérales paramétriques, et

un décodeur (62) selon l'une des revendications 1 à 8 destiné à générer un signal audio non mélangé sur base des un ou plusieurs signaux de mélange vers le bas, et sur base des premières informations latérales paramétriques et des deuxièmes informations latérales paramétriques.

15. Procédé pour générer un signal audio non mélangé comprenant une pluralité de canaux audio non mélangés, dans lequel le procédé comprend le fait de:

déterminer les informations de démélange en recevant des premières informations latérales paramétriques sur l'au moins un signal d'objet audio et des deuxièmes informations latérales paramétriques sur l'au moins un signal d'objet audio, où la résolution de fréquence des deuxièmes informations latérales paramétriques est supérieure à la résolution de fréquence des premières informations latérales paramétriques, et

appliquer les informations de démélange à un signal de mélange vers le bas indiquant un mélange vers le bas d'au moins un signal d'objet audio, pour obtenir un signal audio non mélangé comprenant la pluralité de canaux audio non mélangés,

dans lequel la détermination des informations de démélange comprend le fait de modifier les premières informations paramétriques et les deuxièmes informations paramétriques pour obtenir des informations paramétriques modifiées, de sorte que les informations paramétriques modifiées présentent une résolution de fréquence supérieure à la première résolution de fréquence.

16. Procédé pour coder un ou plusieurs signaux d'objet audio d'entrée, comprenant le fait de:

mélanger vers le bas un ou plusieurs signaux d'objet audio d'entrée pour obtenir un ou plusieurs signaux de mélange vers le bas, et

générer des premières informations latérales paramétriques sur l'au moins un signal d'objet audio et des deuxièmes informations latérales paramétriques sur l'au moins un signal d'objet audio, de sorte que la résolution de fréquence des deuxièmes informations latérales paramétriques soit supérieure à la résolution de fréquence des premières informations latérales paramétriques,

dans lequel les premières informations latérales paramétriques et les deuxièmes informations latérales paramétriques sont générées de sorte que les un ou plusieurs signaux d'objet audio d'entrée puissent être décodés à partir des un ou plusieurs signaux de mélange vers le bas à l'aide des premières informations latérales paramétriques ensemble avec les deuxièmes informations latérales paramétriques.

17. Programme d'ordinateur pour la mise en oeuvre du procédé selon la revendication 15 ou 16 lorsqu'il est exécuté sur un ordinateur ou un processeur de signal.

EP 2 904 609 B1

FIGURE 1A

EP 2 904 609 B1

FIGURE 1B

91

input
audio object
signal(s)

downmix
unit

downmix signal(s)

93

PSI
generator

1st parametric
side information

2nd parametric
side information

FIGURE 2A

FIGURE 2B

EP 2 904 609 B1

| downmix portion | parametric side information portion | |
| | 1st PSI | 2nd PSI |

51

52

FIGURE 2C

input
audio object
signal(s)

61

encoder

downmix signal(s)

$1^{st}$ PSI

$2^{nd}$ PSI

62

decoder

un-mixed
audio signal

FIGURE 3

SAOC encoder

16

obj. $s_1$

obj. $s_2$

obj. $s_N$

mixer

P channel
downmix

18

audio
encoder

10

side
info
estimator

side info

17

mixing parameters
$\{d_{1,1}, ..., d_{N,1}(.d_{1,P}, ..., D_{N,P})\}$

transmission / storage

20

audio
decoder

12

SAOC decoder

(virtual)
object
sepa-
rator

$\hat{s}_{1,est}$

$\hat{s}_{2,est}$

$\hat{s}_{N,est}$

rende-
rer

ch. $\hat{y}_{1,est}$

ch. $\hat{y}_{2,est}$

ch. $\hat{y}_{6,est}$

26

user interaction /
rendering parameters
$\{r_{1,1}, r_{1,2}, ..., r_{N,M})\}$

mono, stereo, or 5.1 channel output

FIGURE 4

EP 2 904 609 B1

FIGURE 5

FIGURE 6

EP 2 904 609 B1

FIGURE 7

FIGURE 8

EP 2 904 609 B1

FIGURE 9

FIGURE 10

EP 2 904 609 B1

FIGURE 11

EP 2 904 609 B1

standard
frequency
resolution part
→

121
decoding

122
convert to
enhanced
frequency
resolution
→

124
combine
→

enhanced
frequency
resolution
PSI
→

enhanced
frequency
resolution part
→

decoding

123

FIGURE 12

FIGURE 13

FIGURE 14

EP 2 904 609 B1

FIGURE 15

FIGURE 16

EP 2 904 609 B1

FIGURE 17

FIGURE 18

EP 2 904 609 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100087938 A1

**Non-patent literature cited in the description**

- **C. FALLER ; F. BAUMGARTE.** Binaural Cue Coding - Part II: Schemes and applications. *IEEE Trans. on Speech and Audio Proc.,* November 2003, vol. 11 (6
- **C. FALLER.** Parametric Joint-Coding of Audio Sources. *120th AES Convention,* 2006
- **J. HERRE ; S. DISCH ; J. HILPERT ; O. HELLMUTH.** From SAC To SAOC - Recent Developments in Parametric Coding of Spatial Audio. *22nd Regional UK AES Conference,* April 2007
- **J. ENGDEGÅRD ; B. RESCH ; C. FALCH ; O. HELLMUTH ; J. HILPERT ; A. HÖLZER ; L. TERENTIEV ; J. BREEBAART ; J. KOPPENS ; E. SCHUIJERS.** Spatial Audio Object Coding (SAOC) - The Upcoming MPEG Standard on Parametric Object Based Audio Coding. *124th AES Convention,* 2008
- MPEG audio technologies - Part 2: Spatial Audio Object Coding (SAOC). *ISO/IEC JTC1/SC29/WG11 (MPEG) International Standard 23003-2:2010*
- **M .BOSI ; K. BRANDENBURG ; S. QUACKENBUSH ; L. FIELDER ; K. AKAGIRI ; H. FUCHS ; M. DIETZ.** ISO/IEC MPEG-2 Advanced Audio Coding. *J. Audio Eng. Soc,* 1997, vol. 45 (10), 789-814
- **M. PARVAIX ; L. GIRIN.** Informed Source Separation of underdetermined instantaneous Stereo Mixtures using Source Index Embedding. *IEEE ICASSP,* 2010
- **M. PARVAIX ; L. GIRIN ; J.-M. BROSSIER.** A watermarking-based method for informed source separation of audio signals with a single sensor. *IEEE Transactions on Audio, Speech and Language Processing,* 2010
- **A. LIUTKUS ; J. PINEL ; R. BADEAU ; L. GIRIN ; G. RICHARD.** Informed source separation through spectrogram coding and data embedding. *Signal Processing Journal,* 2011
- **A. OZEROV ; A. LIUTKUS ; R. BADEAU ; G. RICHARD.** Informed source separation: source coding meets source separation. *IEEE Workshop on Applications of Signal Processing to Audio and Acoustics,* 2011
- **S. ZHANG ; L. GIRIN.** An Informed Source Separation System for Speech Signals. *INTERSPEECH,* 2011
- **L. GIRIN ; J. PINEL.** Informed Audio Source Separation from Compressed Linear Stereo Mixtures. *AES 42nd International Conference: Semantic Audio,* 2011
- **A. NESBIT ; E. VINCENT ; M. D. PLUMBLEY.** Benchmarking flexible adaptive time-frequency transforms for underdetermined audio source separation. *IEEE International Conference on Acoustics, Speech and Signal Processing,* 2009, 37-40